# EUROPEAN PATENT SPECIFICATION

(11) **EP 4 422 210 B1**
(45) Date of publication and mention of the grant of the patent: **16.09.2026**
(21) Application number: 22882929.7
(22) Date of filing: 20.10.2022
(51) Int. Cl.: H04R 1/04, H04R 19/04, B81B 7/00, H04R 19/00, H05F 3/02

(54) **MICROPHONE STRUCTURE, PACKAGING STRUCTURE, AND ELECTRONIC APPARATUS**
MIKROFONSTRUKTUR, VERPACKUNGSSTRUKTUR UND ELEKTRONISCHE VORRICHTUNG
STRUCTURE DE MICROPHONE, STRUCTURE D'EMBALLAGE ET APPAREIL ÉLECTRONIQUE

(30) Priority: 22.10.2021 CN 202122557968 U; 22.10.2021 CN 202122559204 U; 22.10.2021 CN 202122557690 U; 22.10.2021 CN 202122558079 U; 22.10.2021 CN 202122558222 U; 22.10.2021 CN 202122557970 U; 22.10.2021 CN 202122559478 U; 22.10.2021 CN 202122558224 U; 22.10.2021 CN 202122557541 U
(43) Date of publication of application: 28.08.2024
(73) Proprietor: Memsensing Microsystems (Suzhou, China) Co. Ltd, Suzhou, Jiangsu 215127 (CN)
(72) Inventor: LI, Hao, Suzhou, Jiangsu 215123 (CN); MEI, Jiaxin, Suzhou, Jiangsu 215123 (CN); QIAO, Lifeng, Suzhou, Jiangsu 215123 (CN)
(74) Representative: Stöckeler, Ferdinand
(86) International application number: PCT/CN2022/126332
(87) International publication number: WO 2023/066324

(56) References cited:
- CN-A- 106 604 533
- CN-A- 110 475 192
- CN-A- 110 475 192
- CN-A- 110 574 395
- CN-A- 110 574 395
- CN-U- 206 402 448
- CN-U- 215 935 100
- CN-U- 215 935 101
- CN-U- 215 935 102
- CN-U- 215 935 103
- CN-U- 216 054 695
- CN-U- 216 054 696
- CN-U- 216 491 057
- CN-U- 216 626 051
- CN-U- 216 626 052
- US-A1- 2013 034 257
- US-A1- 2018 070 158
- US-A1- 2020 186 907

## Description

### TECHNICAL FIELD

The present disclosure relates to the technical field of micro-electrical-mechanical system, and in particular, relates to a microphone structure, packaging structure, and electronic apparatus.

### BACKGROUND

During the production and use of the semiconductor component and Micro-Electrical-Mechanical System (MEMS), electrostatic discharge may cause irreversible damage to the component, and therefore, it is necessary to provide an antistatic discharge structure in the micro-electrical-mechanical structure(such as microphone structure) based on the printed circuit board (PCB), in order to improve the antistatic discharge performance of the product and reduce the damage to the device caused by the electrostatic discharge (ESD). For microphone structures in the prior art, for example, in the silicon microphone of reference document CN 110475192 A, the electrostatic generated around the sound hole is conducted to the ground through the electrostatic conduction ring, the conductive connection layer and the conductive layer, so as to eliminate the electrostatic and avoid the electrostatic affecting the performance of the silicon microphone.

### BRIEF SUMMARY OF THE INVENTION

According to various embodiments, it is provided a microphone structure in order to solve the problem of irreversible damage to the component due to the electrostatic discharge.

According to various embodiments, this application provides a microphone structure, wherein the microphone structure comprises:
a base component, the base component comprises at least one substrate, the at least one substrate comprises a first substrate, the first substrate has a first surface and a second surface opposite to the first surface, wherein a sound hole is disposed on the first substrate, and the sound hole penetrates through the first substrate in a thickness direction;
a functional assembly, the functional assembly comprises a first functional assembly and a second functional assembly, the first functional assembly comprises an acoustic device and a third functional assembly, the acoustic device is configured to receive a sound wave from the sound hole, the first functional assembly is disposed on the first surface of the first substrate, and the second functional assembly is disposed on the second surface of the first substrate;
the third functional assembly comprises a first metal portion and a first insulating portion, the first metal portion is disposed on the first surface of the first substrate, a part of the first metal portion or all of the first metal portion is covered with the first insulating portion; the second functional assembly comprises a second metal portion and a second insulating portion, the second metal portion is disposed on the second surface of the first substrate, a part of the second metal portion is covered with the second insulating portion, so that one end of the second metal portion facing the sound hole is exposed, the first metal portion is configured to be electrically connected with the ground of the first substrate, the second metal portion is configured to be electrically connected with the ground of the first substrate or electrically connected with the electrostatic discharge circuit of the first substrate, and the first metal portion and the second metal portion are respectively configured to surround the sound hole.

Optionally, wherein the first metal portion further comprises an extension portion, an inner edge of the sound hole is covered with the extension portion, and the extension portion is configured to be electrically connected with the second metal portion, the second metal portion comprises an exposed region exposing out of the second surface of the first substrate, and the exposed region is an entire region or a partial region of the second metal portion.

Optionally, wherein a distance between the first metal portion and the sound hole plus a thickness of the first substrate is greater than a distance between the second metal portion and the sound hole, and/or an area of the first metal portion is smaller than an area of the second metal portion, and/or the distance between the first metal portion and the sound hole is greater than the distance between the second metal portion and the sound hole.

According to a first claimed solution the second metal portion comprises a first grounding component and a second grounding component, the first grounding component and the second grounding component are respectively configured to surround the sound hole.

Wherein the first grounding component and the second grounding component are respectively a metal ring, and an outside diameter of the first grounding component is smaller than an inside diameter of the second grounding component, the sound hole is disposed in an annular region, the annular region is defined by an inside diameter of the first grounding component.

A width of the metal ring constituting the first grounding component is smaller than a width of the metal ring constituting the second grounding component.

The first grounding component and the second grounding component are configured to be electrically connected with the first metal portion through a via hole, the via hole penetrates through the first substrate.

Optionally, a sum of a distance between the first metal portion and a central axis of the sound hole and a distance from the first metal portion to an outer surface of the second functional assembly in a direction of the central axis of the sound hole is greater than a sum of a distance between the first grounding component and the central axis of the sound hole and a distance from the first grounding component to the outer surface of the second functional assembly in a direction of the central axis of the sound hole, and/or an area of the first metal portion is smaller than an area of the first grounding component.

According to a second claimed solution the base component further comprises a second substrate, the second substrate is disposed on a side of the first substrate facing away from the acoustic device, the second functional assembly further comprises a sound guide pipe and a whole machine housing, the sound guide pipe is disposed on the second surface of the first substrate, and the sound guide pipe penetrates through the second substrate and the whole machine housing, the first substrate, the second substrate and the whole machine housing are respectively configured to surround the sound hole.

A metal block is disposed at an end of an inner wall of a pipe body of the sound guide pipe facing away from the acoustic device, and the metal block is configured to expose in a direction of facing the central axis of the sound hole.

Optionally, wherein a thickness of the metal block is smaller than a wall thickness of the pipe body of the sound guide pipe, and a length of the metal block along a direction of axis of the pipe body is smaller than a length of the pipe body of the sound guide pipe.

Optionally, wherein a bending path is defined by the sound guide pipe between the second substrate and the whole machine housing, a length of path of the bending path is greater than a distance from the second substrate to the whole machine housing, a sound wave is configured to enter the sound hole through the bending path.

Optionally, wherein the sound guide pipe comprises a first opening and a second opening, the first opening is configured to communicate with the sound hole, the second opening is configured to communicate with an external space, a central axis of the first opening and a central axis of the second opening are mutually staggered.

According to a third claimed solution at least one tip portion is disposed on the second metal portion, one end of the tip portion is attached to an inner edge of the second metal portion, the other end of the tip portion is configured to extend towards a geometric center of the sound hole.

Optionally, wherein a length of the tip portion is greater than or equal to a distance from the inner edge of the second metal portion to an edge of the sound hole.

Optionally, wherein a projection of each of the tip portion on the second surface of the first substrate is an acute triangle, and a sharp angle of each acute triangle points to the geometric center of the sound hole.

Optionally, an electrostatic interception portion is disposed at an end of the second metal portion close to the sound hole, part of a projection of the sound hole in a direction perpendicular to the first substrate is covered with a projection of the electrostatic interception portion in a direction perpendicular to the first substrate.

Optionally, wherein the electrostatic interception portion comprises at least one baffle, and a part of the sound hole is configured to be blocked by the at least one baffle.

Optionally, wherein the third functional assembly further comprises an electrostatic dredging device, the electrostatic dredging device is configured to absorb an ESD arc enters the acoustic device, and the electrostatic dredging device is configured to discharge the absorbed ESD arc through the first metal portion and the second metal portion.

Optionally, wherein a groove is disposed on the first surface of the first substrate, and the groove protrudes in a direction facing away from the acoustic device, and the groove is configured to place the electrostatic dredging device.

Optionally, wherein in a thickness direction of the first substrate, a depth of the groove is greater than or equal to the height of the electrostatic dredging device.

Optionally, wherein the electrostatic dredging device is a diode device, an anode of the diode device is configured to be electrically connected with the acoustic device, and a cathode of the diode device is configured to be electrically connected with the first metal portion.

The present application further provides a packaging structure, the packaging structure comprises the microphone structure according to any one of the above.

The present application further provides an electronic apparatus, the electronic apparatus comprises the microphone structure according to any one of the above.

**In** the embodiment of the present application, the microphone structure places the sound hole on the base component, and places the acoustic device on the first functional assembly, and when the ESD arc hits from the base component to the sound hole, due to a dielectric strength of the first functional assembly is greater than a dielectric strength of the second functional assembly, the ESD arc is attracted by the second functional assembly with a lower dielectric strength, so that the acoustic device is not easy to be hit by the ESD arc through the sound hole, the acoustic device is protected, and the protection performance of the acoustic device is improved.

### BRIEF DESCRIPTION OF THE DRAWINGS

The technical solutions and other beneficial effects of the present application will be apparent from the following detailed description of specific embodiments of the present application with reference to the accompanying drawings.
FIG. 1 is a first schematic structural diagram of a microphone structure according to this application;
FIG. 2A is a second schematic structural diagram of a microphone structure according to this application;
FIG. 2B is a third schematic structural diagram of a microphone structure according to this application;
FIG. 2C is a fourth schematic structural diagram of a microphone structure according to this application;
FIG. 2D is a fifth schematic structural diagram of a microphone structure according to this application;
FIG. 3A is a first schematic structural diagram of a microphone structure according to a first embodiment of this application;
FIG. 3B is a bottom view of FIG. 3A;
FIG. 3C is a schematic diagram of a second structure of a microphone structure according to a first embodiment of this application;
FIG. 3D is a third schematic structural diagram of a microphone structure according to a first embodiment of this application;
FIG. 3E is a fourth schematic structural diagram of a microphone structure according to a first embodiment of this application;
FIG. 3F is a fifth schematic structural diagram of a microphone structure according to a first embodiment of this application;
FIG. 4A is a schematic structural diagram of a microphone structure according to a second embodiment of this application;
FIG. 4B is a bottom view of FIG. 4A;
FIG. 5A is a first schematic structural diagram of a microphone structure according to a third embodiment of this application;
FIG. 5B is a bottom view of FIG. 5A;
FIG. 5C is a second schematic structural diagram of a microphone structure according to a third embodiment of this application;
FIG. 6A is a schematic structural diagram of a microphone structure according to a fourth embodiment of this application;
FIG. 6B is a bottom view of FIG. 6A;
FIG. 7A is a first schematic structural diagram of a microphone structure according to a fifth embodiment of this application;
FIG. 7B is a bottom view of FIG. 7A;
FIG. 7C is a second schematic structural diagram of a microphone structure according to a fifth embodiment of this application;
FIG. 7D is a bottom view of FIG. 7C;
FIG. 7E is a third schematic structural diagram of a microphone structure according to a fifth embodiment of this application;
FIG. 7F is a bottom view of FIG. 7E;
FIG. 8A is a first schematic structural diagram of a microphone structure according to a non-claimed sixth embodiment of this application;
FIG. 8B is a second schematic structural diagram of a microphone structure according to a non-claimed sixth embodiment of this application;
FIG. 9A is a first schematic structural diagram of a microphone structure according to a seventh embodiment of this application;
FIG. 9B is a second schematic diagram of a microphone structure according to a seventh embodiment of this application;
FIG. 10 is a schematic diagram of a packaging structure according to a non-claimed first example of this application;
FIG. 11 is a schematic diagram of a packaging structure according to a non-claimed second example of this application;
FIG. 12 is a schematic diagram of a packaging structure according to a non-claimed third example of this application;
FIG. 13 is a schematic diagram of a packaging structure according to a non-claimed fourth example of this application.

### IMPLEMENTATIONS OF THIS APPLICATION

The following clearly and completely describes the technical solutions in embodiments of this application with reference to the accompanying drawings in embodiments of this application. It is clear that the described embodiments are merely some but not all of embodiments of this application. All other embodiments obtained by a person skilled in the art based on embodiments of this application without creative efforts shall fall within the protection scope of this application.

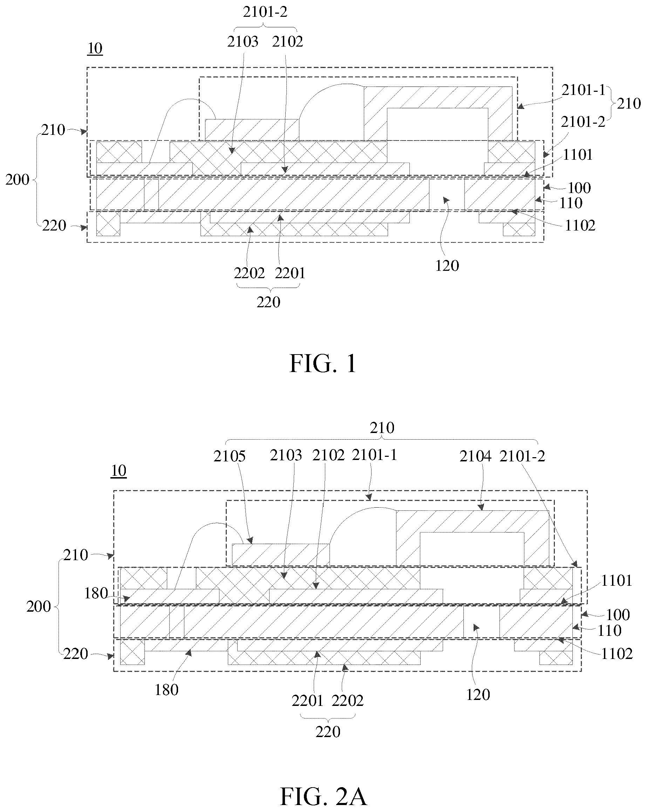

As shown in FIG. 1, an embodiment of this application provides a microphone structure 10, the microphone structure 10 comprises a base component 100 and a functional assembly 200.

Exemplarily, the base component 100 comprises at least one substrate, the at least one substrate comprises a first substrate 110, the first substrate 110 has a first surface 1101 and a second surface 1102 opposite to the first surface 1101, and the first substrate 110 is provided with a sound hole 120, the sound hole 120 penetrates through the first substrate 110 in a thickness direction, and the first substrate 110 may be a glass substrate or made of a resin material.

Exemplarily, the functional assembly 200 comprises a first functional assembly 210 and a second functional assembly 220, the first functional assembly 210 comprises an acoustic device 2101-1 and a third functional assembly 2101-2, the acoustic device 2101-1 is configured to receive sound wave from the sound hole 120, the first functional assembly 210 is disposed on the first surface 1101 of the first substrate 110, and the second functional assembly 220 is disposed on the second surface 1102 of the first substrate 110.

Wherein, the third functional assembly 2101-2 comprises a first metal portion 2102 and a first insulating portion 2103, the first metal portion 2102 is disposed on the first surface 1101 of the first substrate 110, a part of the first metal portion 2102 or all of the first metal portion 2102 is covered with the first insulating portion 2103. The second functional assembly 220 comprises a second metal portion 2201 and a second insulating portion 2202, the second metal portion 2201 is disposed on the second surface 1102 of the first substrate 110, a part of the second metal portion 2201 is covered with the second insulating portion 2202, so that one end of the second metal portion 2201 is exposed, and the end of the second metal portion 2201 is configured to face the sound hole 120, the first metal portion 2102 is configured to be electrically connected to a ground of the first substrate 110, the second metal portion 2201 is configured to be electrically connected with the ground of the first substrate 110 or electrically connected with the electrostatic discharge circuit of the first substrate 110, and wherein the first metal portion 2102 and the second metal portion 2201 are respectively configured to surround the sound hole 120.

In the above content, due to the setting of the second functional assembly 220, the dielectric strength of the second functional assembly 220 is smaller than the dielectric strength of the third functional assembly 2101-2.

The dielectric strength is the measure of the electrical strength of a material as an insulator, the dielectric strength is defined as the maximum voltage withstood by per unit thickness of the sample when the sample is broken down, the dielectric strength is expressed as volts per unit thickness. The greater the dielectric strength of the substance, the better the quality of the substance acts as an insulator. The value of the dielectric strength can be obtained by measuring through the instrument.

Exemplarily, the shape of the sound hole 120 can be circular, or the shape of the sound hole 120 can be a polygon, such as a triangle, a quadrangle, a pentagon, or the like.

In the microphone structure 10 provided in this embodiment of this application, when an ESD arc hits from a side of the first substrate 110 away from the acoustic device 2101-1, the ESD arc is attracted by the second functional assembly 220 with a lower dielectric strength, and the ESD arc can not be easily attracted by the third functional assembly 2101-2, so that the acoustic device 2101-1 is not easy to be hit by the ESD arc through the sound hole 120, the acoustic device 2101-1 is protected, and the ESD protection performance of the acoustic device 2101-1 is improved.

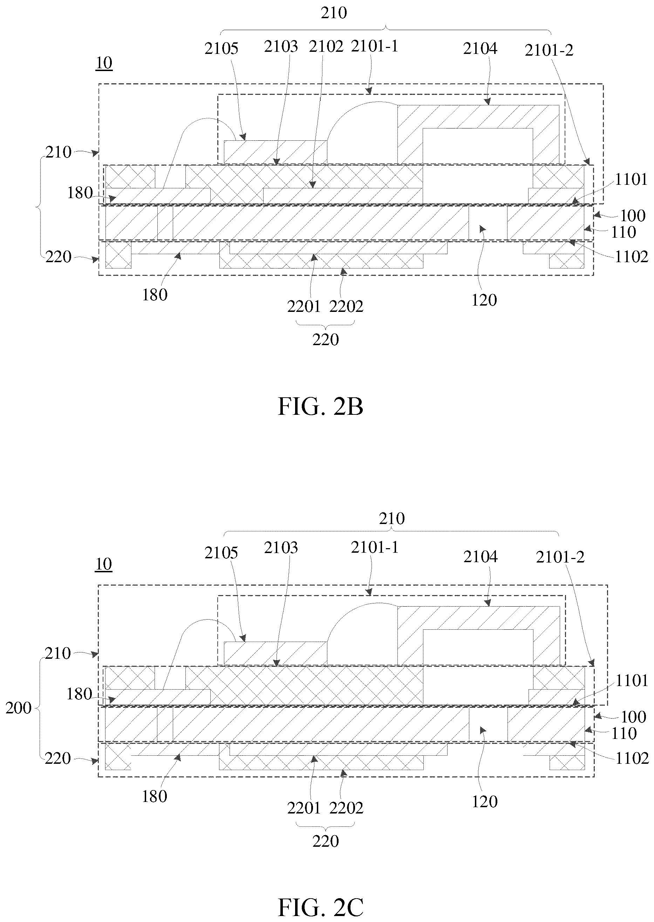

As shown in FIG. 2A and FIG. 2B, the third functional assembly 2101-2 further comprises a first metal portion 2102 and a first insulating portion 2103, the first metal portion 2102 is disposed on the first surface 1101 of the first substrate 110, a part of the first metal portion 2102 or all of the first metal portion 2102 is covered with the first insulating portion 2103, a part of the first metal portion 2102 is covered with the first insulating portion 2103 shown in FIG. 2A, all of the first metal portion 2102 is covered with the first insulating portion 2103 shown in FIG. 2B.

Wherein the second functional assembly 220 comprises a second metal portion 2201 and a second insulating portion 2202, the second metal portion 2201 is disposed on the second surface 1102 of the first substrate 110, a part of the second metal portion 2201 is covered with the second insulating portion 2202, so that one end of the second metal portion 2201 is exposed, and the end of the second metal portion 2201 is configured to face the sound hole 120, the first metal portion 2102 is configured to be electrically connected with the ground of the first substrate 110, the second metal portion 2201 is configured to be electrically connected with the ground of the first substrate 110 or telectrically connected with the electrostatic discharge circuit (not shown) of the first substrate 110, and wherein the first metal portion 2102 and the second metal portion 2201 are respectively configured to surround the sound hole 120.

Exemplarily, an orthographic projection of the first metal portion 2102 on the first substrate 110 can be disposed within an orthographic projection of the acoustic device 2101-1 on the first substrate 110. The first metal portion 2102 is disposed below the acoustic device 2101-1, and the first metal portion 2102 is configured to be electrically connected with the ground of the first substrate 110, so that the first metal portion 2102 can be a grounding metal a part of the acoustic device 2101-1, or the first metal portion 2102 can be a metal ground for reducing interference.

Exemplarily, an orthographic projection of the second metal portion 2201 on the first substrate 110 can be disposed within an orthographic projection of the acoustic device 2101-1 on the first substrate 110. The second metal portion 2201 is also correspondingly disposed below the acoustic device 2101-1, and the second metal portion 2201 and the first metal portion 2102 are disposed opposite to each other. The second metal portion 2201 can be configured to be electrically connected with the ground of the first substrate 110, so that the second metal portion 2201 can be a metal ground for reducing interference. The second metal portion 2201 can also be electrically connected with the electrostatic discharge circuit, and the second metal portion 2201 can guide the ESD arc to the electrostatic discharge circuit to release. The electrostatic discharge circuit can be disposed on the first substrate 110. In case that the first substrate 110 is disposed on other structures, the second metal portion 2201 can be electrically connected with the electrostatic discharge circuit of other structures.

When both of the first metal portion 2102 and the second metal portion 2201 are electrically connected with the ground, the first metal portion 2102 and the second metal portion 2201 can be electrically connected with the ground through other wires of the conductive layer where the first metal portion 2102 and the second metal portion 2201 are disposed, and the first metal portion 2102 and the second metal portion 2201 can also be directly electrically connected through a circuit in a via hole (or referred to as a through hole) in the first substrate 110. The circuit electrically connects the first metal portion 2102, the second metal portion 2201 and the ground is not limited in the embodiments of the present disclosure.

The third functional assembly 2101-2 and the second functional assembly 220 can be regions in the same range surround the sound hole 120, and the third functional assembly 2101-2 and the second functional assembly 220 are disposed in a region below the acoustic device 2101-1. In case that the dielectric strength of the third functional assembly 2101-2 is substantially consistent with the dielectric strength of the second functional assembly 220, when the ESD arc hits the sound hole 120, due to the dielectric strength of the third functional assembly 2101-2 and the dielectric strength of the second functional assembly 220 are consistent, the ESD arc will randomly hit the second functional assembly 220 or the third functional assembly 2101-2. Therefore, in this embodiment of the present disclosure, by changing the structure of the second functional assembly 220 or the third functional assembly 2101-2 in the related art, for example, increasing the dielectric strength of the third functional assembly 2101-2 in the related art, the dielectric strength of the third functional assembly 2101-2 in the embodiment of the present disclosure is greater than the dielectric strength of the second functional assembly 220, thereby solving the problem in the related art that the ESD arc hits the acoustic device 2101-1 through the sound hole 120 to cause the damage of the acoustic device 2101-1.

As shown in FIG. 2C, the main difference between FIG. 2C and FIG. 2A lies in that the third functional assembly 2101-2, the third functional assembly 2101-2 in FIG. 2A comprises the first metal portion 2102 and the first insulating portion 2103, the third functional assembly 2101-2 in FIG. 2B can not comprise the first metal portion 2102, that is, the third functional assembly 2101-2 only comprise s the first insulating portion 2103, and the first insulating portion 2103 is directly adjacent to the first substrate 110. The second functional assembly 220 can comprise a second metal portion 2201 and a second insulating portion 2202, and the second metal portion 2201 is disposed between the second insulating portion 2202 and the first substrate 110.

The first metal portion 2102 may not be disposed on one side of the first substrate 110 facing the acoustic device 2101-1, but the first insulating portion 2103 is directly disposed on the first substrate 110, and the second metal portion 2201 and the second insulating portion 2202 are sequentially disposed on the other side of the first substrate 110 facing away from the acoustic device 2101-1. Due to the first metal portion 2102 is not disposed in the third functional assembly 2101-2, only the first insulating portion 2103 is disposed in the third functional assembly 2101-2, and the second functional assembly 220 comprises the second metal portion 2201 and the second insulating portion 2202, so that the dielectric strength of the third functional assembly 2101-2 without the first metal portion 2102 is significantly greater than the dielectric strength of the second functional assembly 220 having the second metal portion 2201. When an ESD arc hits the sound hole 120, the ESD arc is attracted by the second functional assembly 220 having the second metal portion 2201, and the ESD arc can not be easily attracted by the third functional assembly 2101-2 without the first metal portion 2102, so that the ESD arc is not easy to hit the acoustic device 2101-1 through the sound hole 120, the acoustic device 2101-1 is protected, and the ESD protection performance of the acoustic device 2101-1 is improved.

Wherein the second metal portion 2201 can be partially exposed out of the second insulating portion 2202, so that the ESD arc can be better attracted. The second metal portion 2201 can further have other functions, for example, the second metal portion 2201 has a grounding function, the grounding function can reduce interference near the sound hole 120. For another example, the second metal portion 2201 is configured to serve as a pad, and the second metal portion 2201 can be configured to be electrically connected with other functional devices. Of course, the second metal portion 2201 can also be completely covered by the second insulating portion 2202.

Therefore, the second metal portion 2201 can be grounded so that the interference near the sound hole 120 cab be reduced. The second metal portion 2201 can further have other functions, for example, the second metal portion 2201 is configured to serve as a pad, and the second metal portion 2201 is configured to be electrically connected with other functional devices. The second metal portion 2201 can further be configured to be connected with a circuit for discharging static electricity, thereby discharging static electricity.

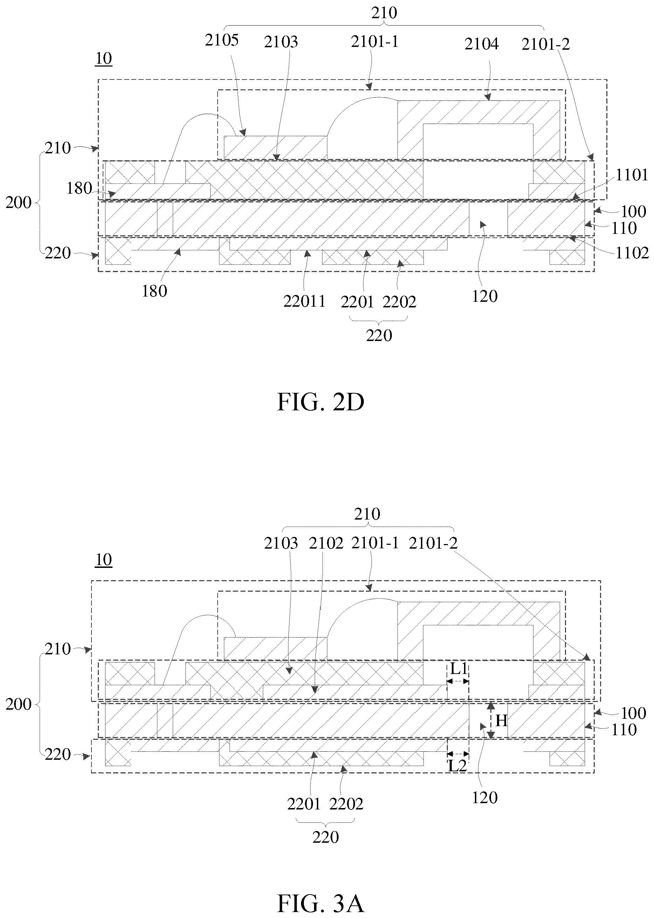

As shown in FIG. 2D, the main difference between FIG. 2D and FIG. 2C lies in the second metal portion 2201. The second metal portion 2201 shown in FIG. 2C can further comprise an exposed sub-part 22015, an orthographic projection of the exposed sub-part 22015 on the first substrate 110 is configured to fall within an orthographic projection of the acoustic device 2101-1 on the first substrate 110, and a side of the exposed sub-part 22015 away from the first substrate 110 is configured to be exposed out of the second insulating portion 2202, so that the ESD arc can be better attracted. The exposed sub-part 22015 can be disposed in an intermediate position of the second metal portion 2201. In some other embodiments, the exposed sub-part 22015 can also be disposed at an edge position of the second metal portion 2201 facing the sound hole 120.

Exemplarily, the material of the first metal portion 2102 and the second metal portion 2201 can be a high-conductivity material, such as copper.

Exemplarily, the first insulating portion 2103 and the second insulating portion 2202 can be ink protective layers.

Exemplarily, the acoustic device 2101-1 can be a Micro-Electro-Mechanical System 2104 (MEMS), an Application Specific Integrated Circuit 2105 (ASIC), and certainly, the acoustic device 2101-1 can also be a device such as a microphone or a speaker of other structures. The micro-electro-mechanical system (MEMS) 2104 is configured to be electrically connected with the application-specific integrated circuit 2105 through a wire, the application-specific integrated circuit (ASIC) 2105 is configured to be electrically connected with a bonding pad 180 on the first substrate 110 through a wire, the bonding pad 180 can be disposed on a side of the first substrate 110 facing the acoustic device 2101-1, the bonding pad 180 cab also be disposed on the other side of the first substrate 110 facing away from the acoustic device 2101-1, and the bonding pads 180 on two sides of the first substrate 110 can configured to be electrically connected through a conductive component or a connecting component, the conductive component or the connecting component is disposed in the via hole of the first substrate 110, so as to facilitate the electrical connection between the acoustic device 2101-1 and other circuits.

In the microphone structure 10 provided in this embodiment of this application, when an ESD arc hits from a side of the first substrate 110 away from the acoustic device 2101-1, the ESD arc is attracted by the second metal portion 2201 having a lower dielectric strength, and the ESD arc can not be easily attracted by the first metal portion 2102, so that the acoustic device 2101-1 is not easy to be hit by the ESD arc through the sound hole 120, the acoustic device 2101-1 is protected, and the ESD protection performance of the acoustic device 2101-1 is improved.

The microphone structure described in this application is described below by quoting any one of the structures shown in FIG. 1 and FIG. 2A -2 D as a basis.

### First Example

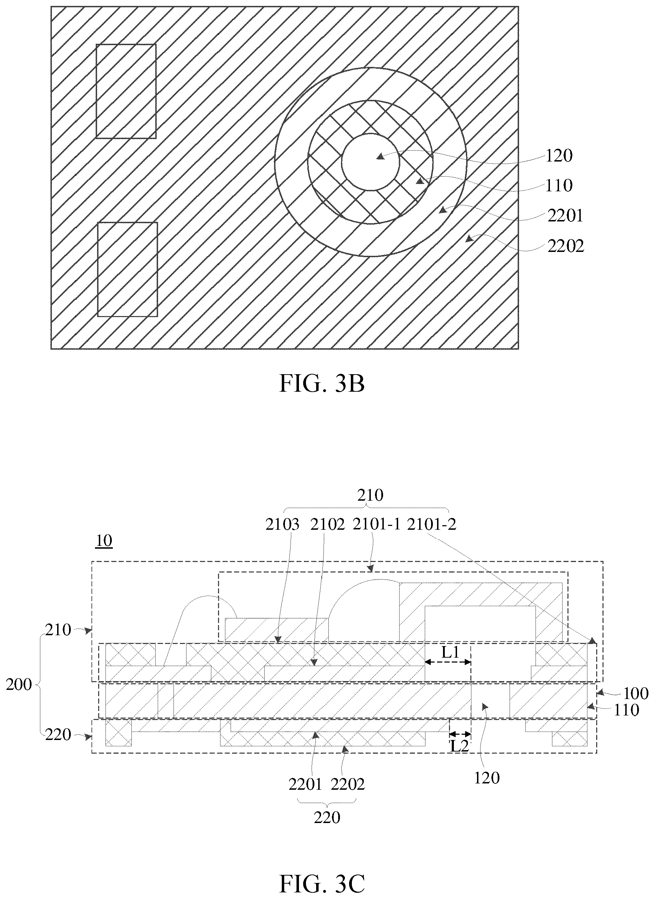

As shown in FIG. 3A and FIG. 3B, the microphone structure 10 comprises a base component 100 and a functional assembly 200, the base component 100 comprises a first substrate 110, the first substrate 110 is provided with a sound hole 120, the functional assembly 200 comprises a first functional assembly 210 and a second functional assembly 220, and the first functional assembly 210 and the second functional assembly 220 are disposed on two sides of the first substrate 110. Wherein the first functional assembly 210 comprises an acoustic device 2101-1, a third functional assembly 2101-2, a first metal portion 2102 and a first insulating portion 2103. The second functional assembly 220 comprises a second metal portion 2201 and a second insulating portion 2202.

The third functional assembly 2101-2 is disposed on a side of the first substrate 110 facing the acoustic device 2101-1, the second functional assembly 220 is disposed on a side of the first substrate 110 facing away from the acoustic device 2101-1, and the third functional assembly 2101-2 and the second functional assembly 220 are respectively configured to surround the sound hole 120. The acoustic device 2101-1 is disposed on the third functional assembly 2101-2, and the acoustic device 2101-1 is disposed opposite to the sound hole 120.

It can thus be seen that, on the basis of FIG. 2A, the distance between the first metal portion 2102 and the second metal portion 2201 is limited in FIG. 3A and FIG. 3B, and the first structure shown in FIG. 3A is that the distance L1 between the first metal portion 2102 and the sound hole 120 plus the thickness H of the first substrate 110 is greater than the distance L2 between the second metal portion 2201 and the sound hole 120, that is, L1 + H> L2.

In the related art, a microphone structure having an acoustic device such as a microphone and other semiconductor devices, in order to improve the shielding performance and reduce the interference, the ground (GND) wiring tends to cover the entire first substrate as much as possible. The two sides of the first substrate are both provided with GND wiring, so that one side (GND) of the first substrate facing the microphone and other semiconductor device products and one side of the first substrate facing away from the microphone both have a bare metal, and the dielectric strength on both sides of the first substrate is basically consistent. When an ESD arc is generated, due to the dielectric strength on both sides of the first substrate is consistent, the ESD arc will randomly hit two sides of the first substrate. If the ESD arc hits the side of the first substrate facing the microphone, the instant explosion can cause huge damage to the fragile microphone and other semiconductor devices.

The acoustic device 2101-1 of the first functional assembly 210 in the embodiment of the present invention is disposed on one side of the first substrate 110, the second functional assembly 220 is disposed on one side of the first substrate 110 facing away from the acoustic device 2101-1, and due to the distance L1 between the first metal portion 2102 and the sound hole 120 plus the thickness H of the first substrate 110 is greater than the distance L2 between the second metal portion 2201 and the sound hole 120, that is, L1 + H> L2. When an ESD arc hits the sound hole 120 from one side of the first substrate 110 facing away from the acoustic device 2101-1, the ESD arc is attracted by the second metal portion 2201, the second metal portion 2201 is closer to the acoustic device 2101, it can also be understood that compared with the ESD arc, the dielectric strength of the third functional assembly 2101-2 is greater than the dielectric strength of the second functional assembly 220, and the ESD arc can be attracted by the second functional assembly 220 with a lower dielectric strength, and the ESD arc can not be easily attracted by the third functional assembly 2101-2, so that the acoustic device 2101-1 is not easy to be hit by the ESD arc through the sound hole 120, thereby the acoustic device 2101-1 is protected, and the ESD protection performance of the acoustic device 2101-1 is improved. Thereby solving the problem in the related art that the ESD arc hits the acoustic device 2101-1 through the sound hole 120 to cause the damage of the acoustic device 2101-1.

Wherein the distance between the first metal portion 2102 and the sound hole 120 can be equal to or slightly smaller than the distance between the second metal portion 2201 and the sound hole 120, for example, the distance between the first metal portion 2102 and the sound hole 120 plus the thickness of the first substrate 110 is greater than the distance between the second metal portion 2201 and the sound hole 120.

In some optional embodiments, as shown in FIG. 3C, considering that the thickness of the first substrate 110 is small, or in order to make the ESD arc better attracted by the second metal portion 2201, and in order to make the first metal portion 2102 can not be hit by the ESD arc through the sound hole 120, and the distance between the first metal portion 2102 and the sound hole 120 shown in FIG. 3C can be greater than the distance between the second metal portion 2201 and the sound hole 120, that is, L1 > L2. In other words, L1 > L2 is defined in FIG. 3C and shows a second structure in FIG. 3C.

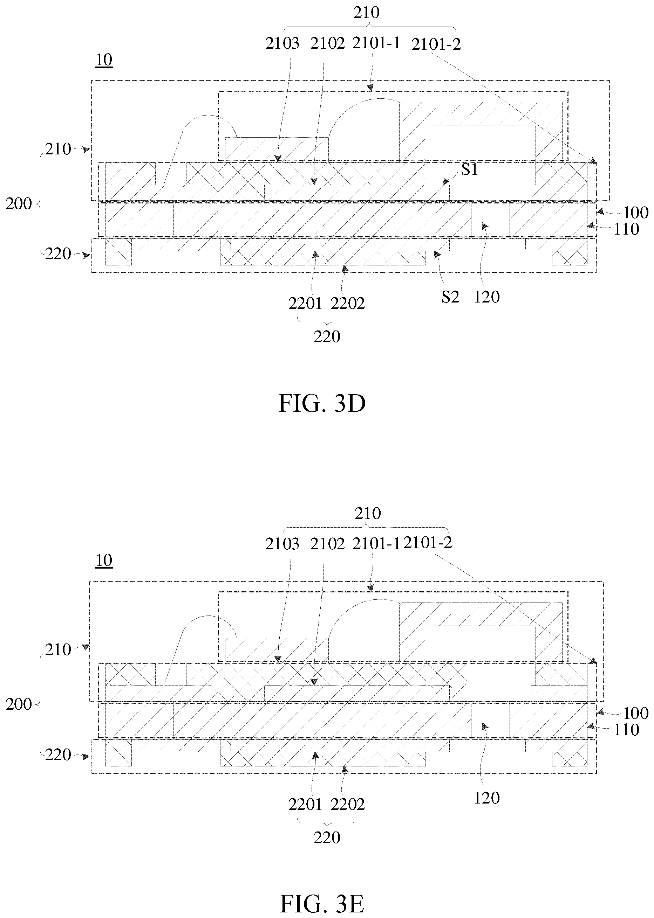

In some optional embodiments, as shown in FIG. 3D, an area of the first metal portion 2102 is smaller than an area of the second metal portion 2201, that is, S1 < S2. In other words, S1 < S2 is defined in FIG. 3D and shows a third structure in FIG. 3D. When an ESD arc hits the sound hole 120 from one side of the first substrate 110 facing away from the acoustic device 2101-1, compared with the ESD arc, the ESD arc is attracted more easily by the second metal portion 2201, it can also be understood that the dielectric strength of the third functional assembly 2101-2 is greater than the dielectric strength of the second functional assembly 220. The ESD arc can be attracted by the second functional assembly 220 with a lower dielectric strength, and the ESD arc can not be easily attracted by the third functional assembly 2101-2, so that the acoustic device 2101-1 is not easy to be hit by the ESD arc through the sound hole 120, thereby the acoustic device 2101-1 is protected, and the ESD protection performance of the acoustic device 2101-1 is improved. Thereby solving the problem in the related art that the ESD arc hits the acoustic device 2101-1 through the sound hole 120 to cause the damage of the acoustic device 2101-1.

It can be understood that, in some embodiments, the distance L1 between the first metal portion 2102 and the sound hole 120 plus the thickness H of the first substrate 110 is greater than the distance L2 between the second metal portion 2201 and the sound hole 120, and the area S1 of the first metal portion 2102 is smaller than the area S2 of the second metal portion 2201, that is, L1 + H > L2 and S1 < S2, so that the dielectric strength of the third functional assembly 2101-2 is greater than the dielectric strength of the second functional assembly 220. In some other embodiments, the distance L1 between the first metal portion 2102 and the sound hole 120 is greater than the distance L2 between the second metal portion 2201 and the sound hole 120, that is, L1 > L2.

When an ESD arc hits the sound hole 120 from one side of the first substrate 110 facing away from the acoustic device 2101-1, the ESD arc can be attracted by the second functional assembly 220 with a lower dielectric strength, and the ESD arc can not be easily attracted by the third functional assembly 2101-2, so that the acoustic device 2101-1 is not easy to be hit by the ESD arc through the sound hole 120, thereby the acoustic device 2101-1 is protected, and the ESD protection performance of the acoustic device 2101-1 is improved. Thereby solving the problem in the related art that the ESD arc hits the acoustic device 2101-1 through the sound hole 120 to cause the damage of the acoustic device 2101-1.

As shown in FIG. 3E, the third functional assembly 2101-2 can further comprise a first insulating portion 2103, and the first metal portion 2102 is covered with the first insulating portion 2103; and the second functional assembly 220 can further comprise a second insulating portion 2202, and a part of the second metal portion 2201 is covered with the second insulating portion 2202.

The first metal portion 2102 and the second metal portion 2201 are disposed on two opposite sides of the first substrate 110. Specifically, the first metal portion 2102 is disposed on one side of the first substrate 110 facing the acoustic device 2101-1, the second metal portion 2201 is disposed on one side of the first substrate 110 facing away from the acoustic device 2101-1, and the first metal portion 2102 and the second metal portion 2201 are respectively configured to surround the sound hole 120. The first metal portion 2102 is covered with the first insulating portion 2103, and a part of the second metal portion 2201 is covered with the second insulating portion 2202. It can also be understood that the first metal portion 2102 is completely covered by the first insulating portion 2103, and a part of the second metal portion 2201 is not covered by the second insulating portion 2202 and is exposed, so that the dielectric strength of the third functional assembly 2101-2 having the first metal portion 2102 is greater than the dielectric strength of the second functional assembly 220 having the second metal portion 2201. When an ESD arc hits the sound hole 120, the ESD arc can be attracted by the second metal portion 2201 which partially exposes out of the second insulating portion 2202, and the ESD arc can not be easily attracted by the first metal portion 2102 completely covered by the first insulating portion 2103, so that the acoustic device 2101-1 is not easy to be hit by the ESD arc through the sound hole 120, the acoustic device 2101-1 is protected, and the ESD protection performance of the acoustic device 2101-1 is improved.

The first insulating portion 2103 and the second insulating portion 2202 can be ink covering the first substrate 110, and the first insulating portion 2103 and the second insulating portion 2202 can protect and insulate the metal portion covered by the first insulating portion 2103 and the second insulating portion 2202. The first metal portion 2102 and the second metal portion 2201 can be metal copper or other conductive metal. It should be noted that both the upper side and the lower side of the first substrate 110 can be provided with a conductive layer, the conductive layer can be formed of metal copper, and the first metal portion 2102 and the second metal portion 2201 can be a part of the corresponding conductive layer.

Wherein the first insulating portion 2103 is configured to cover a side of the first metal portion 2102 facing the sound hole 120, and the second insulating portion 2202 exposes out of a side of the second metal portion 2201 facing the sound hole 120.

In some other embodiments, a side of the first metal portion 2102 facing away from the first substrate 110 can be completely covered by the first insulating portion 2103, a side of the second metal portion 2201 facing away from the first substrate 110 can be partially exposed out of the second insulating portion 2202, and one side of the first metal portion 2102 facing the sound hole 120 and one side of the second metal portion 2201 facing the sound hole 120 can be blocked by the corresponding insulating portion at the same time, or one side of the first metal portion 2102 facing the sound hole 120 and one side of the second metal portion 2201 facing the sound hole 120 can be exposed out of the corresponding insulating portion at the same time.

Optionally, in some other embodiments, the first insulating portion 2103 can be disposed on a side of the first metal portion 2102 facing the sound hole 120, the second insulating portion 2202 can be exposed out of a side of the second metal portion 2201 facing the sound hole 120, meanwhile, a side of the first metal portion 2102 facing away from the first substrate 110 can be completely covered by the first insulating portion 2103, and a side of the second metal portion 2201 facing away from the first substrate 110 can be partially exposed out of the second insulating portion 2202.

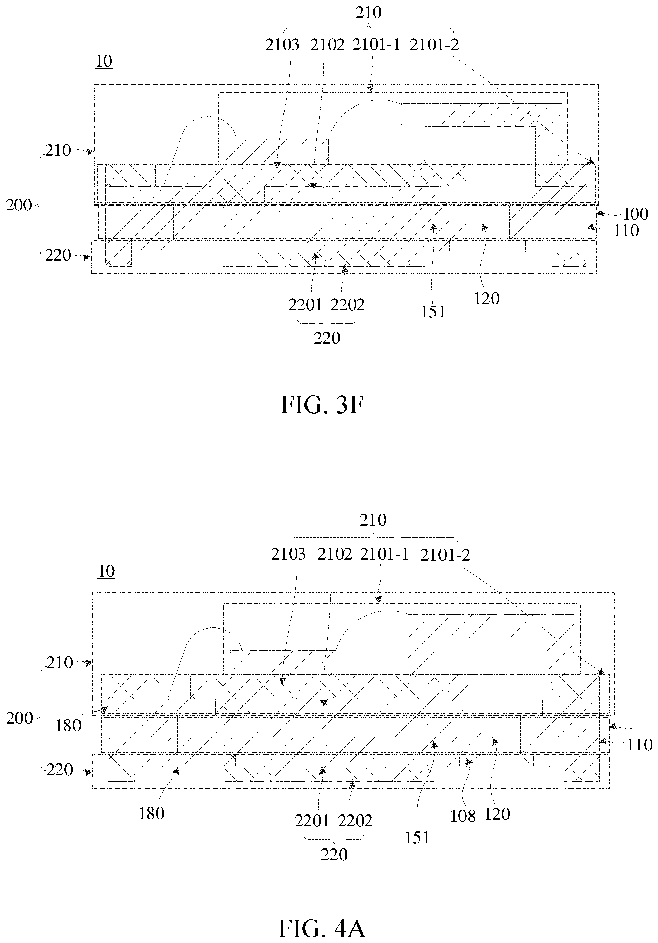

As shown in FIG. 3F, It can be understood that the first metal portion 2102 and the second metal portion 2201 can be insulated, but in another example, the first metal portion 2102 and the second metal portion 2201 can also be electrically connected. The first substrate 110 is provided with a via hole 151, the first metal portion 2102 and the second metal portion 2201 can be in communication with each other through a conductor, and the conductor is configured to pass through the via hole 151, so as to connect the first metal portion 2102 and the second metal portion 2201, and the first metal portion 2102 and/or the second metal portion 2201 can be electrically connected with the ground of the first substrate 110, in this example, due to the connection between the first metal portion 2102 and the second metal portion 2201, the first metal portion 2102 and the second metal portion 2201 can both be configured to be a grounding metal of the acoustic device 2101-1, or can both be configured to be a metal ground for reducing interference. When the second metal portion 2201 is grounded, interference near the sound hole 120 can be reduced, in some embodiments, the second metal portion 2201 can also be completely covered by the second insulating portion 2202, as long as the dielectric strength of the third functional assembly 2101-2 is greater than the dielectric strength of the second functional assembly 220. The first substrate 110 is further provided with a via hole 151, and the via hole 151 is configured to make the acoustic device 2101-1 electrically connect with the first substrate 110, and the acoustic device 2101-1 is configured to be electrically connected with the pad of the first substrate 110 through a wire passing through the via hole 151.

### SECOND Example

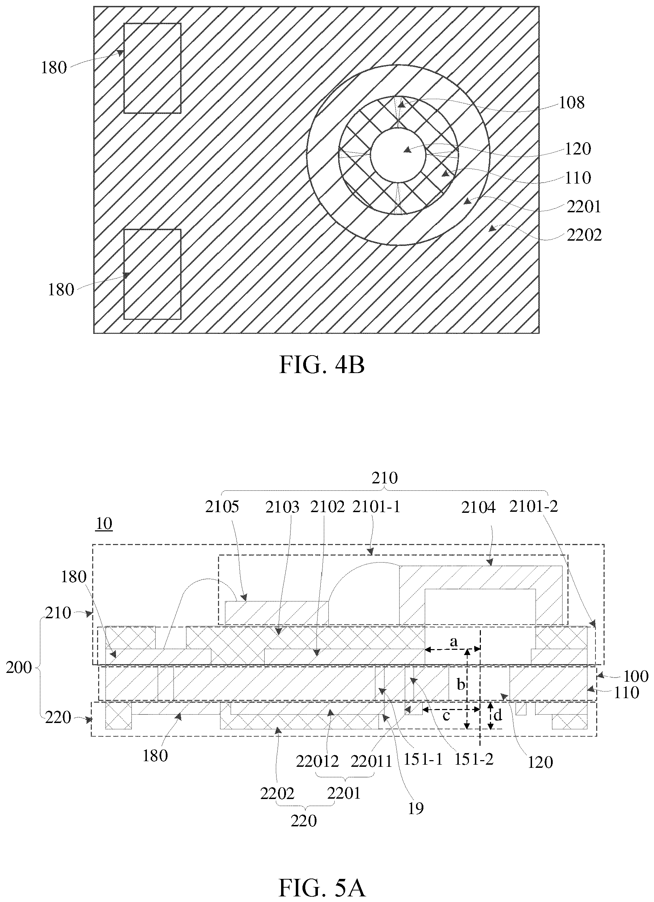

As shown in FIG. 4A and FIG. 4B, in FIG. 4A, at least one tip portion 108 is added on the basis of FIG. 3C, that is, the second metal portion 2201 is further provided with at least one tip portion 108, the at least one tip portion 108 is configured to surround the sound hole 120, one end of the tip portion 108 is attached to the inner edge of the second metal portion 2201, and the other end of the tip portion 108 is configured to extend towards the geometric center of the sound hole 120.

Exemplarily, a length of the tip portion 108 is greater than or equal to a distance from an inner edge of the second metal portion 2201 to an edge of the sound hole 120. For example, FIG. 4A shows that the length of the tip portion 108 is equal to the distance from the inner edge of the second metal portion 2201 to the edge of the sound hole 120, that is, the tip of the tip portion 108 is attached to the edge of the sound hole 120, so that the anti-ESD effect of the present application is better.

Exemplarily, a projection of each tip portion 108 on the first substrate 110 is an acute triangle, and one sharp corner of each acute triangle points to the geometric center of the sound hole 120. Because the tip portion 108 is an acute triangle, that is, the tip portion 108 gradually increases in width from the tip to the bottom, the resistance gradually becomes smaller, which is easier to attract nearby static electricity, so that the anti-ESD effect is better.

Exemplarily, the at least one tip portion 108 can comprise four metal material tip portions (as shown in FIG. 4B), and an interval between adjacent tip portions is 90 degrees. The second metal portion 2201 is configured to be electrically connected with the second metal portion 2201 through the via hole 151, and the via hole 151 penetrates through the first substrate 110.

It can be understood that the tip portion can also be other shapes, and the number can also be not limited to the four shown in FIG. 4B, so that the number and shape of the tip portion are not limited in this application.

In an actual PCB design, in order to prevent the sound hole from entering the tin slag, the diameter design of the second metal portion 2201 (the metal ring shown in FIG. 4B) is often as large as possible, so that a superposition of the dielectric strength of the metal ring and the air is greater than the dielectric strength of the third functional assembly 2101-2, and when the ESD arc reaches the inlet of the sound hole 120, the ESD arc preferentially enters the product, and when the air explodes, irreversible damage is caused to the acoustic device (such as the MEMS device and the ASIC device) inside the product.

Thus, in the present application, the protruding tip portion 108 is disposed on the inner side of the second metal portion 2201, and the protruding tip is closer to the sound hole 120. When the ESD arc reaches the inlet of the sound hole 120 of the product, because the ESD arc is preferentially attracted by the low-dielectric-strength tip portion 108 near the outside of the product, and the ESD arc can not be attracted by the third functional assembly 2101-2 with high dielectric strength, so that the acoustic device 2101-1 inside the product can not be hit by the ESD arc, thereby greatly reducing the influence of the sensitive acoustic device 2101-1 by the ESD arc. After the ESD arc is attracted by the tip portion 108 of the second metal portion 2201, energy is discharged through the protection circuit grounded to the second metal portion 2201.

### THIRD Example

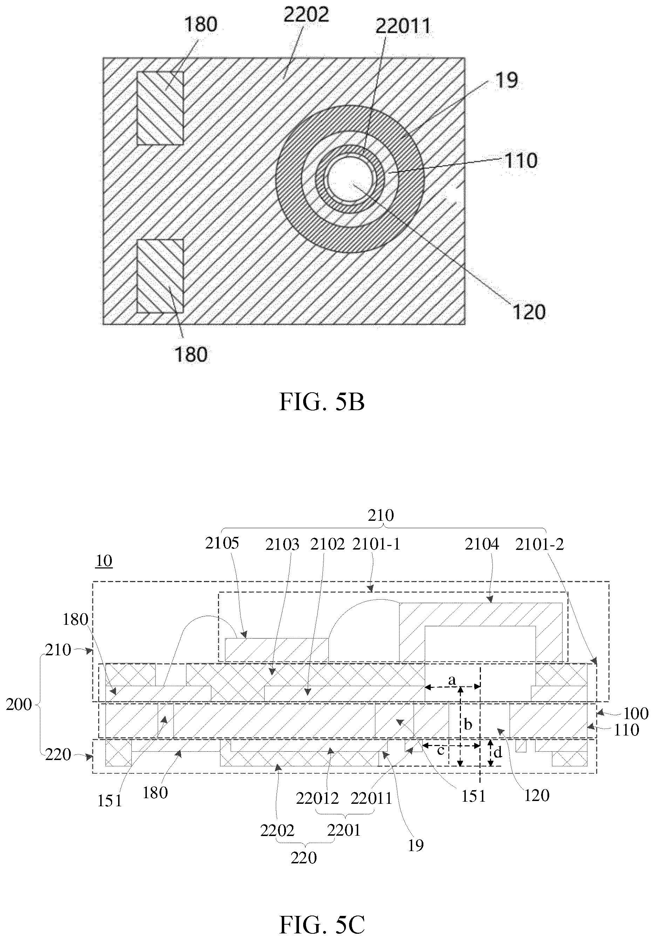

As shown in FIG. 5A and FIG. 5B, the main difference between FIG. 5A and FIG. 2B is the second metal portion 2201, so the description of other same parts in the embodiment of the present invention can refer to the above embodiment, details are not described herein again. The second metal portion 2201 shown in FIG. 5A comprises a first grounding component 22011 and a second grounding component 22012, and the first grounding component 22011 and the second grounding component 22012 are respectively configured to surround the sound hole 120.

Wherein the first grounding component 22011 and the second grounding component 22012 are respectively configured to surround the sound hole 120. In this way, the first grounding component 22011 and the second grounding component 22012 form a concentric double-ring structure, and as can be seen from the above, the first grounding component 22011 is closer to the sound hole 120 than the second grounding component 22012, so that the ESD arc around the sound hole 120 can be attracted by the first grounding component 22011 more easily. Therefore, when the ESD arc outside the microphone structure hits the microphone structure, at one end of the sound hole 120 close to the second surface of the first substrate 110, the ESD arc is preferentially attracted by the first grounding component 22011, and the grounding component 22011 is closer to the sound hole 120, thereby preventing the ESD arc from entering the microphone structure through the sound hole 120, thereby preventing the acoustic device 2101-1 in the microphone structure from being damaged by the ESD arc.

On the other hand, because the first grounding component 22011 is disposed on the inner side of the second grounding component 22012, the first grounding component 22011 can block the solder ball on the second grounding component 22012 to prevent the solder ball from falling into the sound hole 120, thereby prolonging the service life of the microphone. Therefore, the microphone structure of the present application can reduce the probability that an ESD arc enters the microphone and prolong the service life of the microphone.

Exemplarily, the first grounding component 22011 can be a ring-shaped structure surrounding the sound hole 120. It can be understood that the first grounding component 22011 can not be limited as an annular structure, or the first grounding component 22011 can be a square structure surrounding the sound hole 120, the structure of the first grounding component 22011 is not limited in this application. The second grounding component 22012 can also be a ring-shaped structure surrounding the sound hole 120. Similarly, the second grounding component 22012 is not limited as an annular structure, or the second grounding component 22012 can be a square structure surrounding the sound hole 120, the structure of the second grounding component 22012 is not limited in this application.

Exemplarily, the first grounding component 22011 and the second grounding component 22012 are respectively a metal ring. The material of the first grounding component 22011 and the second grounding component 22012 can be a high-conductivity material. For example, the material of the metal ring is copper.

In a further example, an outside diameter of the first grounding component 22011 is smaller than an inside diameter of the second grounding component 22012. That is, a gap is disposed between the first grounding component 22011 and the second grounding component 22012, so that the first grounding component 22011 and the second grounding component 22012 are spaced apart. The sound hole 120 is disposed in an annular region defined by an inside diameter of the first grounding component 22011.

Exemplarily, a width of the metal ring constituting the first grounding component 22011 is smaller than a width of the metal ring constituting the second grounding component 22012. For example, the second grounding component 22012 is disposed laterally on the second surface (i.e. the lower surface) of the first substrate 110. The lateral arrangement can be that the second grounding component 22012 extends in a direction parallel to the substrate. The second grounding component 22012 can be configured to be electrically connected with a zero potential or a reference potential.

Exemplarily, a part of the second grounding component 22012 is covered with the second insulating portion 2202 to form an exposed grounding region 19 in a direction close to the sound hole 120.

Exemplarily, the first metal portion 2102 is configured to surround the sound hole 120. A sum of the distance a between the first metal portion 2102 and the central axis distance of the sound hole 120 and the distance b from the first metal portion 2102 to the outside surface of the second functional assembly 220 (i.e. the lower surface of the second functional assembly 220) in a direction of the central axis of the sound hole 120 is greater than a sum of the distance c between the first grounding component 22011 and the sound hole 120 and the distance d between the first grounding component 22011 and the outer surface of the second functional assembly 220 (i.e. the lower surface of the second functional assembly 220), that is, a + b > c + d; and/or the area of the first metal portion 2102 is smaller than the area of the first grounding component 22011. When an ESD arc hits, the ESD arc can be attracted by the first grounding component 22011 of the second metal portion 2201, and the ESD arc can not be easily attracted by the first metal portion 2102, so that the acoustic device 2101-1 is protected and the ESD protection performance of the acoustic device 2101-1 is improved.

Exemplarily, the first grounding component 22011 and the second grounding component 22012 are respectively configured to be electrically connected with the first metal portion 2102 through a via hole, and the via hole penetrates through the first substrate 110. Specifically, an electrical conductor is disposed in the via hole. The electrical conductor is configured to be electrically connected with the first metal portion 2102 and the second grounding component 22012. In this way, the first metal portion 2102 can be electrically connected with the second grounding component 22012 through the electrical conductor.

Exemplarily, the microphone structure in this embodiment of this application further comprises an electrostatic discharge circuit (not shown in the figure). The electrostatic discharge circuit can be electrically coupled with the first grounding component 22011. The electrostatic discharge circuit is configured to discharge static electricity absorbed by the first grounding component 22011.

It can be seen from the above that, compared with the second grounding component 22012, the ESD arc around the sound hole 120 can be attracted by the first grounding component 22011 more easily, the first grounding component 22011 is closer to the sound hole 120, and the static electricity generated by the ESD arc attracted by the first grounding component 22011 is conducted to the electrostatic discharge circuit, and the static electricity is discharged by the electrostatic discharge circuit.

It should be noted that the number of the via hole can be two, as shown in FIG. 5A, the two via holes (151-1, 151-2) are respectively a first via hole 151-1 and a second via hole 151-2 penetrates through the first substrate 110 from the first surface (i.e. the upper surface) of the first substrate 110 to the second surface (i.e. the lower surface), the first grounding component 22011 is configured to be electrically connected with the first metal portion 2102 through the second via hole 151-2, and the second grounding component 22012 is configured to be electrically connected with the first metal portion 2102 through the first via hole 151-1.

In another embodiment, as shown in FIG. 5C, the number of the via hole is one, that is, via hole 151. The first grounding component 22011 and the second grounding component 22012 are respectively configured to be electrically connected with one end of the via hole 151. The first metal portion 2101-1 is configured to be electrically connected with the other end of the via hole 151.

### FOURTH Example

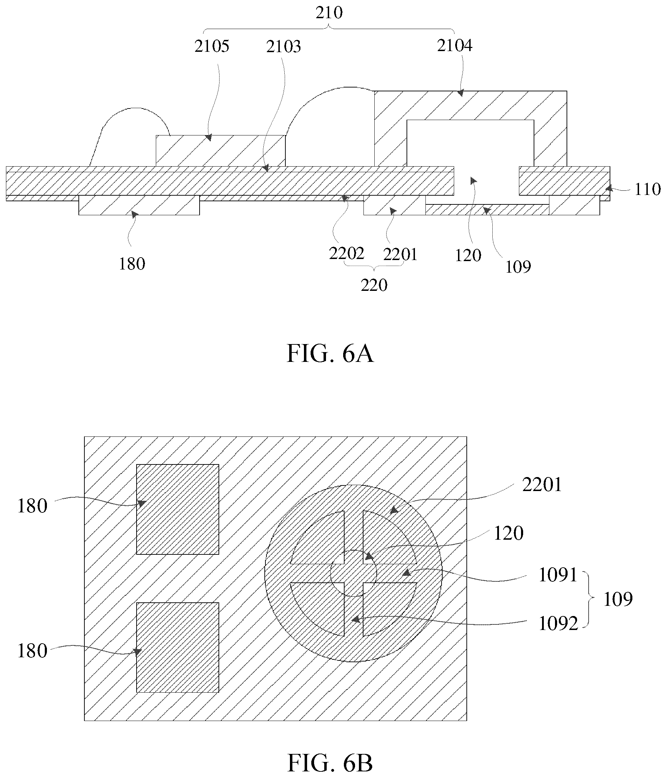

As shown in FIG. 6A and FIG. 6B, the main difference between FIG. 6A and FIG. 4A lies in the second metal portion 2201, and the second metal portion 2201 is disposed on the second surface of the first substrate 110, and the second metal portion 2201 is configured to surround the sound hole 120. At one end close to the sound hole 120 of the second metal portion 2201 shown in FIG. 4A is provided with a tip portion 108, an electrostatic interception portion 109 is disposed at one end close to the sound hole 120 of the second metal portion 2201 shown in FIG. 6A, a part of the projection of the sound hole 120 in a direction perpendicular to the first substrate 110 is covered with the projection of the electrostatic interception portion 109 in the direction perpendicular to the first substrate 110, and the dielectric strength of the electrostatic interception portion 109 is smaller than the dielectric strength of the third functional assembly 2101-2.

Exemplarily, the electrostatic interception portion 109 comprises at least one baffle, and a part of the sound hole 120 is configured to be blocked by the at least one baffle, so that an external sound wave can enter the acoustic device 2101-1 through a gap that is not blocked by the baffle.

Exemplarily, the width of each baffle can be smaller than the diameter of the sound hole 120, so that the external sound wave can enter the acoustic device 2101-1 through a gap that is not blocked by the baffle.

Exemplarily, the microphone structure in this embodiment of this application further comprises an electrostatic discharge circuit (not shown in the figure). The electrostatic discharge circuit can be configured to be electrically coupled with the second metal portion 2201. The electrostatic discharge circuit is configured to discharge static electricity absorbed by the second metal portion 2201.

Wherein the FIG. 6A shows that the second metal portion 2201 is a metal ring, and the electrostatic interception portion 109 comprises a first baffle 1091 and a second baffle 1092 (as shown in FIG. 6B), and the first baffle 1091 and the second baffle 1092 are vertically disposed on the same plane, and the first baffle 1091 and the second baffle 1092 are made of metal material, but the number and shape of the baffle are not limited in this application.

The third functional assembly 2101-2 shown in FIG. 6A comprises a first insulating portion 2103, the second functional assembly 220 comprises a second metal portion 2201 and a second insulating portion 2202, the first surface (i.e. the upper surface) of the first substrate 110 is covered with the first insulating portion 2103, and a part of the second surface (i.e. the lower surface) of the first substrate 110 is covered with the second insulating portion 2202. The setting of the third functional assembly 2101-2 and the second functional assembly 220 can also refer to the above embodiment, the setting is not limited to the example shown in FIG. 6A, for example, the third functional assembly 2101-2 can also comprise a first metal portion and a first insulating portion, the first metal portion is disposed on the first surface of the first substrate, and part or all of the first metal is covered with the first insulating portion.

### FIFTH Example

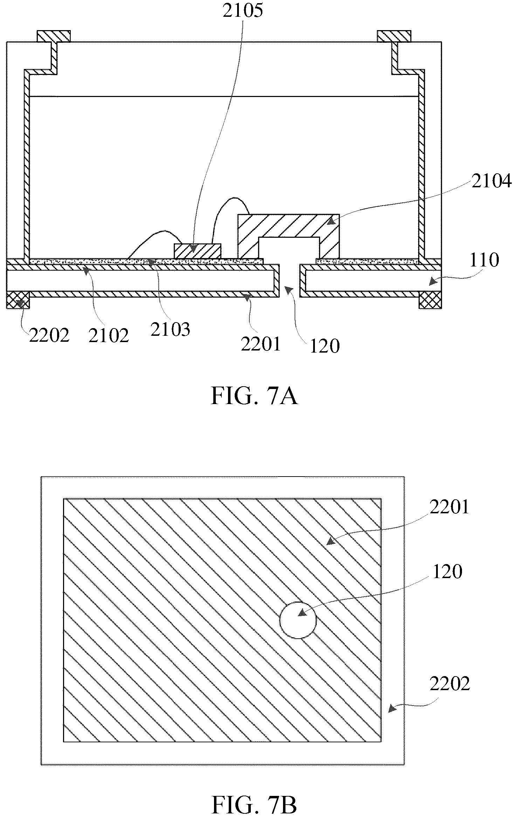

As shown in FIG. 7A and FIG. 7B, the first metal portion 2102 further comprises an extension portion (not shown), an inner edge of the sound hole 120 is covered with the extension portion, and the extension portion is configured to be electrically connected with the second metal portion 2201, the second metal portion 2201 comprises an exposed region, exposing out of a second surface (i.e. a lower surface) of the first substrate 110, and the exposed region is an entire region or a partial region of the second metal portion 2201.

A part of the first metal portion 2102 is covered with the first insulating portion 2103 shown in FIG. 7A, and the second metal portion 2201 can not be covered with the second insulating portion 2202, so that it can be seen from FIG. 7B that the exposed region is basically the entire region of the second metal portion 2201.

The extension portion enables the first metal portion 2102 and the second metal portion 2201 to be electrically connected, and the second metal portion 2201 is partially exposed or completely exposed, and when an ESD arc hits the sound hole 120 from one side of the first substrate 110 facing away from the acoustic device 2101-1, the ESD arc is attracted by the second metal portion 2201 that is closer to the ESD arc and is not blocked by the second insulating portion 2202, the ESD arc is not easy to be attracted by the first metal portion 2102 that is farther away from the ESD arc and is blocked by the first insulating portion 2103. It can also be understood that the ESD arc can be attracted by the second metal portion 2201 having a lower dielectric strength, and the edge of the sound hole 120 is also configured to communicate with the second metal portion 2201 through the extension portion, so that the ESD arc is not easy to hit the acoustic device through the sound hole 120, the acoustic device is protected, and the ESD protection performance of the acoustic device is improved.

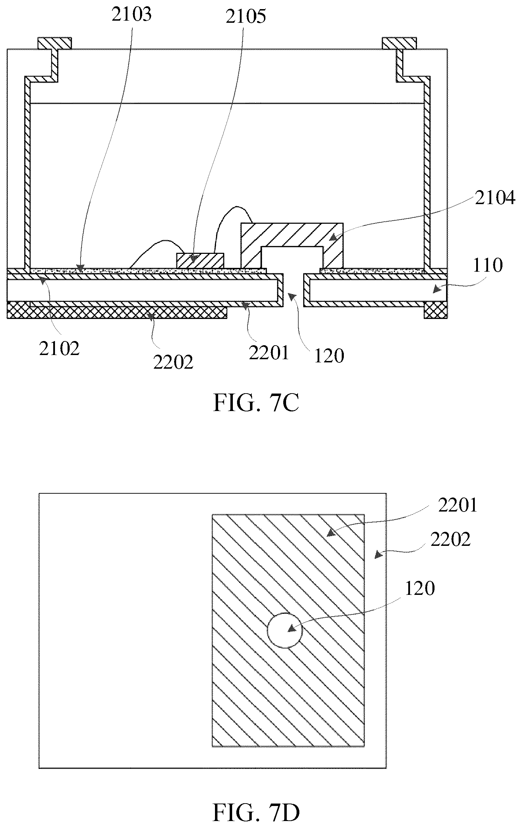

As shown in FIG. 7C and FIG. 7D, the difference between FIG. 7C and FIG. 7A lies in that a part of the second metal portion 2201 is covered with the second insulating portion 2202 shown in FIG. 7C, for example, it can be seen from FIG. 7D that a half of the region of the second metal portion 2201 is covered with the second insulating portion 2202.

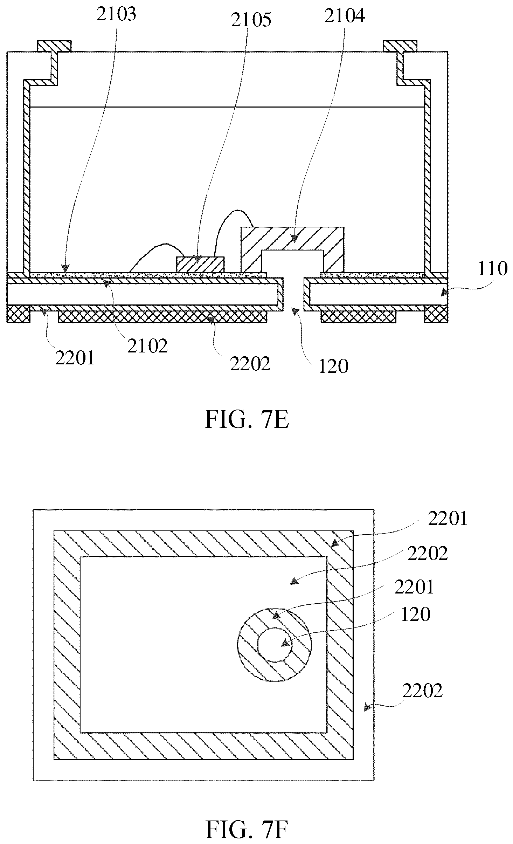

As shown in FIG. 7E and FIG. 7F, the difference between FIG. 7E and FIG. 7C lies in that a part of the second metal portion 2201 is covered with the second insulating portion 2202 shown in FIG. 7E, and the second insulating portion 2202 presents an annular interval shape, for example, as can be seen from FIG. 7G, the second metal portion 2201 is covered with the second insulating portion 2202 at an annular interval surrounds the sound hole 120, that is, the exposed region comprises a rectangular annular metal region of the second metal portion 2201 and a circular metal region surrounding the sound hole 120. The width of the rectangular annular metal region and the width of the annular metal exposed region are not limited in the present application, and the shape of the exposed region is not limited in the present application.

### SIXTH Example

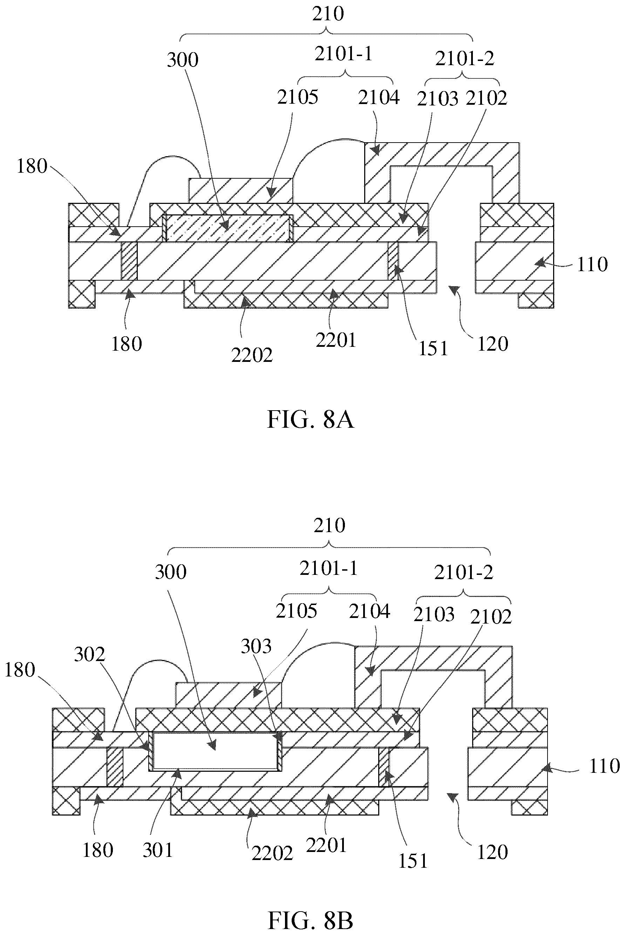

As shown in FIG. 8A, according to a non-claimed example the third functional assembly 2101-2 further comprises an electrostatic dredging device 300, the electrostatic dredging device 300 is configured to absorb the ESD arc enters the acoustic device 2101-1 and discharge the absorbed ESD arc through the first metal portion 2102 and the second metal portion 2201. The electrostatic dredging device 300 can be disposed on the first surface of the first substrate 110, the acoustic device 2101-1 is configured to be electrically connected with the electrostatic dredging device 300 through the bonding pad 180 on the first substrate 110, the electrostatic dredging device 300 is also configured to be electrically connected with the first metal portion 2102, and the first metal portion 2102 is configured to be electrically connected with the second metal portion 2201 through the via hole 151 to form a conductive link, and the via hole 151 penetrates through the first substrate 110.

Exemplarily, a part of the projection of the acoustic device 2101-1 on the first surface of the first substrate 110 can overlap with the projection of the electrostatic dredging device 300 on the first surface of the first substrate 110, for example, the electrostatic dredging device 300 can be disposed close to one end of the application-specific integrated circuit 2105, so that the electrostatic dredging device 300 is disposed closer to the acoustic device 2101-1 that needs to be protected, so that the conductive link between the electrostatic dredging device 300 and the application-specific integrated circuit 2105 is relatively short, the ESD arc enters the microphone product can be quickly absorbed by the electrostatic dredging device 300, and the absorbed ESD arc can be discharged through the grounding circuit, the grounding circuit is configured to be electrically connected with the first metal portion 2102 and/or the second metal portion 2201, prevent the acoustic device 2101-1 from the damage caused by the electrostatic.

The present application further provides another structure, in order to utilize the space more reasonably, the electrostatic dredging device 300 can be partially embedded into the first substrate 110, as shown in FIG. 8B. A groove 301 is disposed on the first substrate 110, the groove 301 protrudes in a direction facing away from the acoustic device 2101-1, and the electrostatic dredging device 300 is disposed in the groove 301. In the thickness direction of the first substrate 110, the depth of the groove 301 can be greater than or equal to the height of the electrostatic dredging device 300, in order to place the electrostatic dredging device 300 conveniently and save space.

Therefore, through the structure provided in FIG. 8B, the electrostatic dredging device 300 can be disposed in the groove 301 in the first substrate 110, so that the surface of the first substrate 110 can still be kept flat after the electrostatic dredging device 300 is disposed in the groove 301, and the subsequent assembly of the acoustic device 2101-1 can not be affected, and because the space above the first substrate 110 does not need to be occupied, the space utilization rate of the first substrate 110 facing the acoustic device can be improved.

Exemplarily, in order to improve the convenience and reliability of electrical access of the electrostatic dredging device 300, at least two groups of welding pad can be disposed on a side wall of the groove 301, wherein one group of welding pad 302 is configured to connect the electrostatic dredging device 300 with the bonding pad 180, and the other group of welding pad 303 is configured to connect the electrostatic dredging device 300 with the first metal portion 2102. Therefore, by arranging the welding pad on the side wall of the groove 301, installation and electrical conduction of the electrostatic dredging device 300 are facilitated.

Exemplarily, the electrostatic dredging device 300 shown in the present application is a diode device, an anode of the diode device is configured to be electrically connected with a corresponding pad 180, and a cathode of the diode device is configured to be electrically connected with the first metal portion 2102.

Exemplarily, in one embodiment, the diode device can be an ESD diode. The ESD diode is an overvoltage and anti-static protection element, the ESD diode is a device designed for the I/O port protection of a high-speed data transmission application, and the ESD diode can be configured to prevent the sensitive circuit in the electronic apparatus from being affected by ESD (electrostatic discharge). The working principle of the ESD diode is as follows:
The ESD diode is connected in parallel to the circuit, and when the circuit works normally, the ESD diode is in an off state (high resistance state) and does not affect normal operation of the circuit; when the circuit has an abnormal overvoltage and reaches breakdown voltage of the circuit, the ESD diode quickly changes from the high resistance state to the low resistance state and provides a low impedance conduction path for the instantaneous current, and the ESD diode clamps the abnormal high voltage within a safety level, thereby protecting the protected IC or the circuit; when the abnormal overvoltage disappears, the ESD diode returns to a high resistance state, and the circuit works normally; when the voltage exceeds the turn-on voltage of the ESD diode, the ground is conducted to release the voltage; because the normal signal voltage generally can not reach the turn-on voltage of the ESD diode, the loss is not generated by conducting the ground, and the ESD voltage generally exceeds the turn-on voltage of the ESD diode, The ESD diode is turned on, and the ESD voltage is released by grounding, so as to protect the post-stage circuit without damaging internal components of the microphone.

Exemplarily, in one embodiment, the diode device can also be a transient voltage suppressor diode (i.e. TVS tube) device. The anode of the TVS tube is configured to be electrically connected with the pad 180, and the cathode of the TVS tube is configured to be electrically connected with the first metal portion 2102. When the two poles of the TVS tube experience instantaneous high-energy impact, the TVS tube can reduce the high impedance between the two poles into a low impedance in a extremely high speed (up to 1/(10 ^ 12) seconds), and the surge power (large current) with up to several kilowatts is absorbed by the TVS tube, so that the voltage between the two poles is clamped at a predetermined value, thereby ensuring that the subsequent circuit components are prevented from being damaged by transient high-energy impact. Moreover, the TVS tube has the advantages of small volume, high power, no noise, low price and the like. Optionally, the TVS tube is a bidirectional TVS tube to prevent the AC large current from damaging components of the post-stage circuit.

Therefore, in the present application, the electrostatic dredging device is disposed on the first substrate, the electrostatic dredging device is configured to be electrically connected with the acoustic device via the conductive link, and part or the projection of the acoustic device on the first substrate can overlap with the projection of the electrostatic dredging device on the first substrate, so that the electrostatic dredging device is closer to the circuit for protecting the acoustic device. When an ESD arc is generated, the electrostatic arc is preferentially absorbed quickly by the electrostatic dredging device, and the acoustic device (such as a MEMS device and an ASIC device) inside the microphone product can not be hit by the arc, thereby reducing the influence of the sensitive MEMS device and the ASIC device on the ESD arc.

### SEVENTH Example

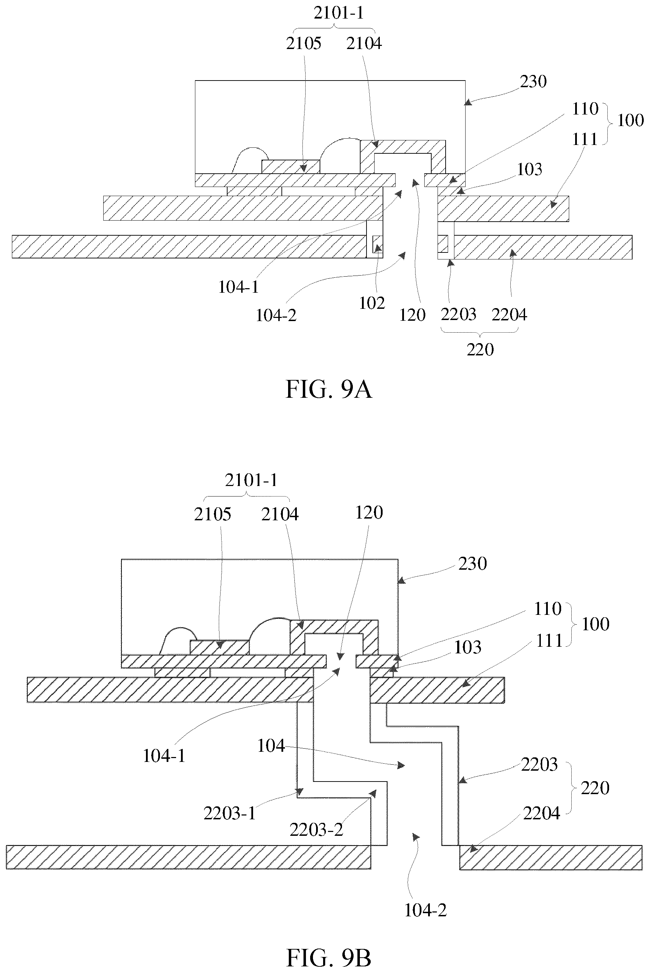

The base component 100 further comprises a second substrate 111, the second substrate 111 is disposed on a side of the first substrate 110 facing away from the acoustic device 2101-1, the second functional assembly 220 further comprises a sound guide pipe 2203 and a whole machine housing 2204, the sound guide pipe 2203 is disposed on the second surface of the first substrate 110 and penetrates through the second substrate 111 and the whole machine housing 2204, and the first substrate 110, the second substrate 111, and the whole machine housing 2204 are respectively configured to surround the sound hole 120. The sound guide pipe 2203 forms a path 104, the path 104 has a first opening 104-1 and a second opening 104-2, the first opening 104-1 is configured to communicate with the sound hole 120, the second opening 104-2 is configured to communicate with an external space, and the central axis of the first opening 104-1 and the central axis of the second opening 104-2 can be the same central axis (as shown in FIG. 9A) or mutually staggered with each other (as shown in FIG. 9B).

Exemplarily, the first substrate 110 can be a PCB board, and the second substrate 111 can be a PCBA (i.e. Printed Circuit Board Assembly) board, for example, the PCB board can be directly soldered to the PCBA board of the electronic apparatus through the bonding pad. The acoustic device 2101-1 located on the first surface of the first substrate 110 can be packaged by a shielding cover (i.e. a package housing) 230. The first substrate 110 is configured to be connected with the second substrate 111 through a connecting structure 103.

Exemplarily, the shape of the sound hole 120 and the sound guide pipe 2203 can be polygonal, for example, the polygon can be a triangle, a quadrangle, a pentagon, or the like. Therefore, the shape of the sound hole 120 and the shape of the sound guide pipe 2203 are not limited in this application.

As shown in FIG. 9A, a metal block 102 is disposed at an end (i.e. the front end of the sound guide pipe) of the inner wall of the pipe body of the sound guide pipe 2203 facing away from the acoustic device, and the metal block 102 is configured to expose in a direction of facing the central axis of the sound hole 120, the ESD arc enters from the front end of the sound guide pipe 2203 can be attracted by the exposed a part of the metal block 102.

Exemplarily, the thickness of the metal block 102 is smaller than the wall thickness of the pipe body of the sound guide pipe 2203, and the length of the metal block 102 along the axis direction of the pipe body is smaller than the length of the pipe body of the sound guide pipe 2203.

Because the metal block 102 is disposed at the front end of the sound guide pipe 2203, when an ESD arc enters the sound guide pipe 2203 from the side facing away from the acoustic device 2101-1, the ESD arc can be attracted and discharged by the metal block 102, and the distance for the static electricity reaches the acoustic device 2101-1 inside the microphone is increased by the sound guide pipe 2203, the influence of the instantaneous air pressure changes on the acoustic device 2101-1 is weakened by the sound guide pipe 2203, thereby the probability that the ESD arc enters the interior of the acoustic device 2101-1 is reduced, thereby the ESD resistance of the microphone is improved.

Exemplarily, the metal block 102 can be configured to surround the sound guide pipe 2203 in an annular shape, or a plurality of metal blocks 102 can be configured to surround the inner wall of the sound guide pipe 2203, and the plurality of metal blocks 102 are spaced apart, so that the shape and quantity of the metal block are not limited in this application.

In the related solution of the art known by the inventor, because the acoustic device 2101-1 is disposed inside the microphone, when an ESD arc hits the sound guide pipe 2203, due to the difference of the dielectric strength, the ESD arc can be attracted by the bare tin and the boding pad during SMT (i.e. Surface Mounted Technology) of the microphone, so that the distance between the position of the ESD arc and the acoustic device 2101-1 is only several hundred microns, which causes the acoustic device 2101-1 can not withstand the instantaneous air pressure changes, thereby causing permanent damage to the acoustic device 2101-1. Therefore, in the present application, by providing the sound guide pipe 2203 and disposing the metal block 102 in the pipe body of the sound guide pipe 2203, the distance for the ESD arc reaches the acoustic device 2101-1 inside the microphone is lengthened, and the attracted ESD arc can be discharged by the metal block 102 at the front end of the sound guide pipe 2203, thereby the probability that the ESD arc enters the interior of the sound guide pipe 2203 is reduced, thereby the ESD resistance of the microphone is improved.

As shown in FIG. 9B, a bending path 104 is defined by the sound guide pipe 2203 between the second substrate 111 and the whole machine housing 2204, the path length of the bending path 104 is greater than the distance between the second substrate 111 and the whole machine housing 2204, a sound wave from the external space is configured to enter the bending path 104 from the second opening 104-2, and the external sound wave is configured to enter the sound hole 120 through the bending path 104 and the first opening 104-1, so that the external sound wave can be transmitted to the acoustic device 2101-1 through the sound guide pipe 2203 and the sound hole 120. Further, the acoustic device 2101-1 can be configured to receive the external sound wave.

Exemplarily, the central axis of the first opening 104-1 and the central axis of the second opening 104-2 are mutually staggered, and because the second opening 104-2 is not directly facing the acoustic device 2101-1, the distance between the ESD arc enters from the second opening 104-2 and the acoustic device 2101-1 is relatively long, thereby avoiding the situation of a part of the structure of the acoustic device 2101-1 is damaged due to the difficulty of withstanding the transient high voltage of the ESD arc.

Exemplarily, the sound guide pipe 2203 comprises a first bending part 2203-1 and a second bending part 2203-2, for example, the bending angles of the first bending part 2203-1 and the second bending part 2203-2 can be 90 degrees. In this way, the sound guide pipe 2203 is configured to bend through the first bending part 2203-1 and the second bending part 2203-2, and a folding structure is defied by the sound guide pipe 2203, that is, a three-segment folding structure is defined by the sound guide pipe 2203 through the first bending part 2203-1 and the second bending part 2203-2. Therefore, the path length of the sound guide pipe 2203 is the sum of the path lengths of the three-segment folding structure. It can be seen from the above that the path length of the sound guide pipe 2203 is greater than the distance between the whole machine housing 2204 and the base component 100. In other words, with respect to the linear structure, the path length of the sound guide pipe 2203 with the folding structure is longer.

The path length of the bending path 104 shown in FIG. 9B is longer than the path length of the unbent path 104 shown in FIG. 9A, and the path length of the bending path 104, so that the length of the path that a sound wave propagates from the external space to the sound hole 120 becomes longer. When an ESD arc is concentrated on the outer side of the sound guide pipe 2203, the distance between the ESD arc and the acoustic device 2101-1 is increased, so that the ESD arc can be preferentially discharged from the outer side of the sound guide pipe 2203 without entering the interior of the sound hole 120, so that the acoustic device 2101-1 can withstand the transient high voltage of the ESD arc to achieve the purpose of improving the ESD resistance of the product.

It can be understood that although the structures of the first metal portion, the first insulating portion, the second metal portion, and the second insulating portion are not shown in FIG. 9A and FIG. 9B, based on FIG. 9A and FIG. 9B, the present disclosure can also comprise a structure of one or more component combinations of the first metal portion, the first insulating portion, the second metal portion, and the second insulating portion, and details are not described herein again.

In addition, this application further provides a packaging structure, where the packaging structure comprises a microphone structure in any one of the foregoing embodiments.

Specific non-claimed examples of the packaging structure are described below.

### Example 1

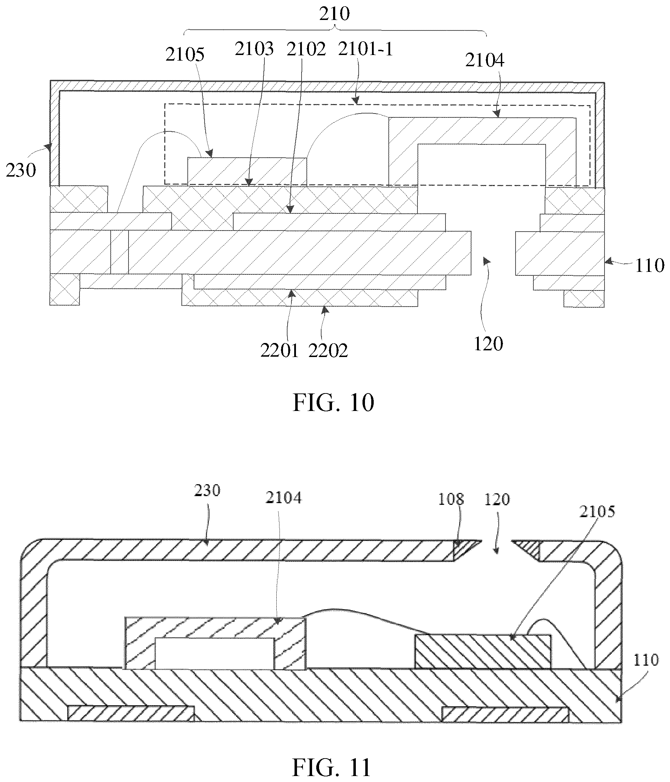

As shown in FIG. 10, in addition to the microphone structure in any one of the foregoing embodiments, the packaging structure can further comprise a shielding cover 230, and the shielding cover can be a metal housing for packaging a device. The acoustic device 2101-1 (for example, the micro-electromechanical system 2104 and the application-specific integrated circuit 2105) can be covered with the shielding cover 230. The shielding cover 230 is also disposed on a side of the first substrate 110 facing the micro-electro-mechanical system 2104 and the application-specific integrated circuit 2105, and the micro-electro-mechanical system 2104 and the application-specific integrated circuit 2105 can completely be covered with the shielding cover 230, thereby the micro-electro-mechanical system 2104 and the application-specific integrated circuit 2105 can be protected, so that the acoustic device 2101-1 can not be affected by static electricity located in one side of the acoustic device 2101-1 facing away from the first substrate 110. The other side of the acoustic device 2101-1 is the first substrate 110, the first substrate 110 can also protect the acoustic device 2101-1, and the static electricity near the acoustic hole 120 on the first substrate 110 is attracted away by the second metal portion 2201, so that the acoustic device 2101-1 can be protected in all directions from being affected by the static electricity. Of course, the static electricity can be defended by the packaging structure from the side of the acoustic device 2101-1 facing away from the first substrate 110 in other manners, such as providing an electrostatic guiding circuit or the like. The shielding cover 230 can also serve as a package housing for the micro-electro-mechanical system 2104 and the application-specific integrated circuit 2105.

### Example 2

Generally, the sound hole is disposed on the first substrate, but in practical application, the sound hole can also be disposed on the shielding cover, that is, the sound hole can be disposed at any position of the shielding cover.

As shown in FIG. 11, the packaging structure compries a shielding cover 230, and the description of the shielding cover 230 can refer to the foregoing embodiments, and details are not described herein again.

Exemplarily, a sound hole 120 is disposed on any position of the shielding cover 230, and the sound hole 120 penetrates through the shielding cover 230 in a thickness direction, at least one tip portion 108 is disposed on the shielding cover 230, and the at least one tip portion 108 is configured to surround the sound hole 120, and the tip portion 108 is configured to extend towards the geometric center of the sound hole 120. The descriptions of the tip portion 108 can refer to the foregoing descriptions in FIG. 4 A to FIG. 4 B, and details are not described herein again.

### Example 3

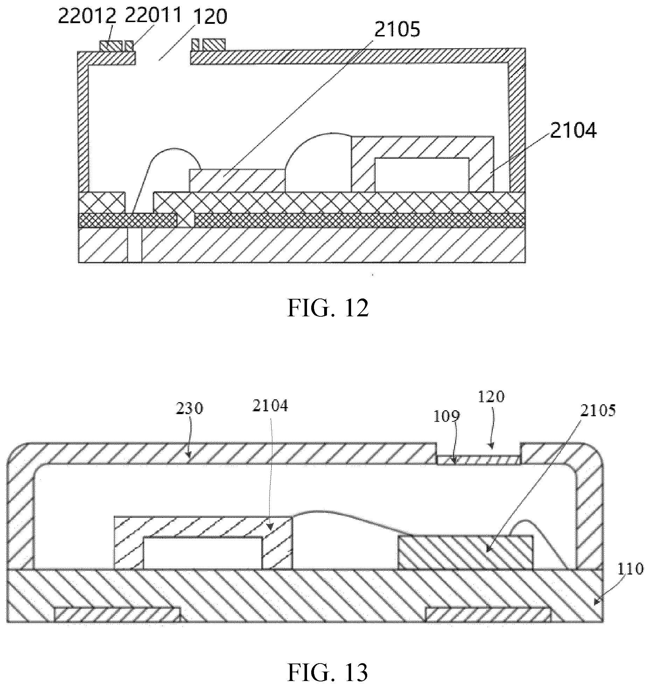

As shown in FIG. 12, the packaging structure comprises a shielding cover 230, and the description of the shielding cover 230 can refer to the foregoing embodiments, and details are not described herein again.

Exemplarily, a sound hole 120 is disposed on any position of the shielding cover 230, and the sound hole 120 penetrates through the shielding cover 230 in a thickness direction, a first grounding component 22011 and a second grounding component 22012 are disposed on the shielding cover 230, and the first grounding component 22011 and the second grounding component 22012 are configured to surround the sound hole 120, and the structures of the first grounding component 22011 and the second grounding component 22012 are as shown in FIG. 5A, and details are not described herein again.

A concentric bicyclic structure is defined by the first grounding component 22011 and the second grounding component 22012. Thus, compare with the second grounding component 22012, the first grounding component 22011 is closer to the sound hole 120, so that the ESD arc surrounding the sound hole 120 can be attracted by the first grounding component 22011 more easily. Further, the first grounding component 22011 can be a ring-shaped structure surrounding the sound hole 120.

### Example 4

As shown in FIG. 13, the packag3 structure comprises a shielding cover 230, and the description of the shielding cover 230 can refer to the foregoing embodiments, and details are not described herein again.

Exemplarily, a sound hole 120 is disposed on any position of the shielding cover 230, and the sound hole 120 penetrates through the shielding cover 230 in a thickness direction, an electrostatic interception portion 109 is disposed on the shielding cover 230, and the electrostatic interception portion 109 is configured to surround the sound hole 120, and a dielectric strength of the electrostatic interception portion 109 is smaller than a dielectric strength of an internal space of the packaging structure, wherein a part of a projection of the sound hole 120 in a direction perpendicular to the first substrate 110 is covered with a projection of the electrostatic interception portion 109 in a direction perpendicular to the first substrate 110. The structure of a similar component is as shown above, and details are not described herein again.

In addition, this application further provides an electronic apparatus, where the electronic apparatus can comprise the microphone structure in any one of the foregoing embodiments, and a structure of a similar component is as shown above, and details are not described herein again.

Exemplarily, the electronic apparatus can be any device having an audio playing function, such as a mobile phone, a sound box, a tablet computer, a television, a notebook computer, a point reader, or any device having a device for converting a sound signal into an electrical signal or converting an electrical signal into a sound signal, the type of the electronic apparatus is not limited in the embodiment of the present application.

The microphone structure provided in the embodiments of this application are described in details above, and the principle and implementation manners of this application are described herein by using specific examples, and the descriptions of the foregoing embodiments are merely used to help understand the method and the core idea of the present application; in conclusion, the content of the present specification should not be construed as a limitation to the present application.

## Claims

1. A microphone structure (10), wherein the microphone structure (10) comprises:
a base component (100), the base component (100) comprises at least one substrate, the at least one substrate comprises a first substrate (110), the first substrate (110) has a first surface (1101) and a second surface (1102) opposite to the first surface (1101), wherein a sound hole (120) is disposed on the first substrate (110), and the sound hole (120) penetrates through the first substrate (110) in a thickness direction; and
a functional assembly (200), the functional assembly (200) comprises a first functional assembly (210) and a second functional assembly (220), the first functional assembly (210) comprises an acoustic device (2101-1) and a third functional assembly (2101-2), the acoustic device (2101-1) is configured to receive a sound wave from the sound hole (120), the first functional assembly (210) is disposed on the first surface (1101) of the first substrate (110), and the second functional assembly (220) is disposed on the second surface (1102) of the first substrate (110);
wherein the third functional assembly (2101-2) comprises a first metal portion (2102) and a first insulating portion (2103), the first metal portion (2102) is disposed on the first surface (1101) of the first substrate (110), a part of the first metal portion (2102) or all of the first metal portion (2102) is covered with the first insulating portion (2103); the second functional assembly (220) comprises a second metal portion (2201) and a second insulating portion (2202), the second metal portion (2201) is disposed on the second surface (1102) of the first substrate (110), a part of the second metal portion (2201) is covered with the second insulating portion (2202), so that one end of the second metal portion (2201) facing the sound hole (120) is exposed, the first metal portion (2102) is configured to be electrically connected with the ground of the first substrate (110), the second metal portion (2201) is configured to be electrically connected with the ground of the first substrate (110) or electrically connected with an electrostatic discharge circuit, and the first metal portion (2102) and the second metal portion (2201) are respectively configured to surround the sound hole (120);
**characterized in that** the second metal portion (2201) comprises a first grounding component (22011) and a second grounding component (22012) respectively surrounding the sound hole (120), both the first grounding component (22011) and the second grounding component (22012) are metal rings, an outside diameter of the first grounding component (22011) is smaller than an inside diameter of the second grounding component (22012), the sound hole (120) is disposed in an annular region defined by an inside diameter of the first grounding component (22011), a width of the metal ring constituting the first grounding component (22011) is smaller than a width of the metal ring constituting the second grounding component (22012), and the first grounding component (22011) and the second grounding component (22012) are electrically connected with the first metal portion (2102) through a via hole penetrating through the first substrate (110).

2. The microphone structure (10) according to claim 1, wherein a distance (L1) between the first metal portion (2102) and the sound hole (120) plus a thickness (H) of the first substrate (110) is greater than a distance (L2) between the second metal portion (2201) and the sound hole (120), and/or an area (S1) of the first metal portion (2102) is smaller than an area (S2) of the second metal portion (2201), and/or the distance (L1) between the first metal portion (2102) and the sound hole (120) is greater than the distance (L2) between the second metal portion (2201) and the sound hole (120).

3. The microphone structure (10) according to claim 1, wherein a sum of a distance (a) between the first metal portion (2102) and a central axis of the sound hole (120) and a distance (b) from the first metal portion (2102) to an outer surface of the second functional assembly (220) in a direction of the central axis of the sound hole (120) is greater than a sum of a distance (c) between the first grounding component (22011) and the central axis of the sound hole (120) and a distance (d) from the first grounding component (22011) to the outer surface of the second functional assembly (220) in a direction of the central axis of the sound hole (120), and/or an area of the first metal portion (2102) is smaller than an area of the first grounding component (22011).

4. The microphone structure (10) according to claim 1, wherein the base component (100) further comprises a second substrate (111), the second substrate (111) is disposed on a side of the first substrate (110) facing away from the acoustic device (2101-1), the second functional assembly (220) further comprises a sound guide pipe (2203) and a whole machine housing (2204), the sound guide pipe (2203) is disposed on the second surface (1102) of the first substrate (110), and the sound guide pipe (2203) runs through the second substrate (111) and the whole machine housing (2204), the first substrate (110), the second substrate (111) and the whole machine housing (2204) are respectively configured to surround the sound hole (120).

5. The microphone structure (10) according to claim 4, wherein a metal block (102) is disposed at an end of an inner wall of a pipe body of the sound guide pipe (2203) facing away from the acoustic device (2101-1), and the metal block (102) is configured to expose towards an inner wall of the sound hole (120);
a thickness of the metal block (102) is smaller than a wall thickness of the pipe body of the sound guide pipe (2203), and a length of the metal block (102) along a direction of axis of the pipe body is smaller than a length of the pipe body of the sound guide pipe (2203).

6. The microphone structure (10) according to claim 4, wherein a bending path (104) is defined by the sound guide pipe (2203) between the second substrate (111) and the whole machine housing (2204), a length of path of the bending path (104) is greater than a distance from the second substrate (111) to the whole machine housing (2204), a sound wave is configured to enter the sound hole (120) through the bending path (104);
the sound guide pipe (2203) comprises a first opening (104-1) and a second opening (104-2), the first opening (104-1) is configured to communicate with the sound hole (120), the second opening (104-2) is configured to communicate with an external space, a central axis of the first opening (104-1) and a central axis of the second opening (104-2) are mutually staggered.

7. The microphone structure (10) according to claim 1, wherein the third functional assembly (2101-2) further comprises an electrostatic dredging device (300), the electrostatic dredging device (300) is configured to absorb an ESD arc entering the acoustic device (2101-1), and the electrostatic dredging device (300) is configured to discharge the absorbed ESD arc through the first metal portion (2102) and the second metal portion (2201).

8. The microphone structure (10) according to claim 7, wherein a groove (301) is disposed on the first surface (1101) of the first substrate (110), and the groove (301) protrudes in a direction facing away from the acoustic device (2101-1), and the groove (301) is configured to place the electrostatic dredging device (300);
a depth of the groove (301) is greater than or equal to the height of the electrostatic dredging device (300) in a thickness direction of the first substrate (110);
the electrostatic dredging device (300) is a diode device, an anode of the diode device is configured to be electrically connected with the acoustic device (2101-1), and a cathode of the diode device is configured to be electrically connected with the first metal portion (2102).

9. A microphone structure (10), wherein the microphone structure (10) comprises:
a base component (100), the base component (100) comprises at least one substrate, the at least one substrate comprises a first substrate (110), the first substrate (110) has a first surface (1101) and a second surface (1102) opposite to the first surface (1101), wherein a sound hole (120) is disposed on the first substrate (110), and the sound hole (120) penetrates through the first substrate (110) in a thickness direction; and
a functional assembly (200), the functional assembly (200) comprises a first functional assembly (210) and a second functional assembly (220), the first functional assembly (210) comprises an acoustic device (2101-1) and a third functional assembly (2101-2), the acoustic device (2101-1) is configured to receive a sound wave from the sound hole (120), the first functional assembly (210) is disposed on the first surface (1101) of the first substrate (110), and the second functional assembly (220) is disposed on the second surface (1102) of the first substrate (110);
wherein the third functional assembly (2101-2) comprises a first metal portion (2102) and a first insulating portion (2103), the first metal portion (2102) is disposed on the first surface (1101) of the first substrate (110), a part of the first metal portion (2102) or all of the first metal portion (2102) is covered with the first insulating portion (2103); the second functional assembly (220) comprises a second metal portion (2201) and a second insulating portion (2202), the second metal portion (2201) is disposed on the second surface (1102) of the first substrate (110), a part of the second metal portion (2201) is covered with the second insulating portion (2202), so that one end of the second metal portion (2201) facing the sound hole (120) is exposed, the first metal portion (2102) is configured to be electrically connected with the ground of the first substrate (110), the second metal portion (2201) is configured to be electrically connected with the ground of the first substrate (110) or electrically connected with an electrostatic discharge circuit, and the first metal portion (2102) and the second metal portion (2201) are respectively configured to surround the sound hole (120);
**characterized in that** the base component (100) further comprises a second substrate (111), the second substrate (111) is disposed on a side of the first substrate (110) facing away from the acoustic device (2101-1), the second functional assembly (220) further comprises a sound guide pipe (2203) and a whole machine housing (2204), the sound guide pipe (2203) is disposed on the second surface (1102) of the first substrate (110) and penetrates through the second substrate (111) and the whole machine housing (2204), and the first substrate (110), and the second substrate (111) and the whole machine housing (2204) are respectively configured to surround the sound hole (120); and a metal block (102) is disposed at an end of an inner wall of a pipe body of the sound guide pipe (2203) facing away from the acoustic device (2101-1), and the metal block (102) is configured to expose towards an inner wall of the sound hole (120).

10. The microphone structure (10) according to claim 9, wherein a thickness of the metal block (102) is smaller than a wall thickness of the pipe body of the sound guide pipe (2203), and a length of the metal block (102) along a direction of axis of the pipe body is smaller than a length of the pipe body of the sound guide pipe (2203).

11. A microphone structure (10), wherein the microphone structure (10) comprises:
a base component (100), the base component (100) comprises at least one substrate, the at least one substrate comprises a first substrate (110), the first substrate (110) has a first surface (1101) and a second surface (1102) opposite to the first surface (1101), wherein a sound hole (120) is disposed on the first substrate (110), and the sound hole (120) penetrates through the first substrate (110) in a thickness direction; and
a functional assembly (200), the functional assembly (200) comprises a first functional assembly (210) and a second functional assembly (220), the first functional assembly (210) comprises an acoustic device (2101-1) and a third functional assembly (2101-2), the acoustic device (2101-1) is configured to receive a sound wave from the sound hole (120), the first functional assembly (210) is disposed on the first surface (1101) of the first substrate (110), and the second functional assembly (220) is disposed on the second surface (1102) of the first substrate (110);
wherein the third functional assembly (2101-2) comprises a first metal portion (2102) and a first insulating portion (2103), the first metal portion (2102) is disposed on the first surface (1101) of the first substrate (110), a part of the first metal portion (2102) or all of the first metal portion (2102) is covered with the first insulating portion (2103); the second functional assembly (220) comprises a second metal portion (2201) and a second insulating portion (2202), the second metal portion (2201) is disposed on the second surface (1102) of the first substrate (110), a part of the second metal portion (2201) is covered with the second insulating portion (2202), so that one end of the second metal portion (2201) facing the sound hole (120) is exposed, the first metal portion (2102) is configured to be electrically connected with the ground of the first substrate (110), the second metal portion (2201) is configured to be electrically connected with the ground of the first substrate (110) or electrically connected with an electrostatic discharge circuit, and the first metal portion (2102) and the second metal portion (2201) are respectively configured to surround the sound hole (120);
**characterized in that** at least one tip portion (108) is disposed on the second metal portion (2201), one end of the tip portion (108) is attached to an inner edge of the second metal portion (2201), the other end of the tip portion (108) is configured to extend towards a geometric center of the sound hole (120).

12. The microphone structure (10) according to claim 11, wherein a length of the tip portion (108) is greater than or equal to a distance from the inner edge of the second metal portion (2201) to an edge of the sound hole (120); or
a projection of each tip portion (108) on the second surface (1102) of the first substrate (110) is an acute triangle, and a sharp angle of each acute triangle points to the geometric center of the sound hole (120).

13. The microphone structure (10) according to claim 11, wherein an electrostatic interception portion (109) is disposed at an end of the second metal portion (2201) close to the sound hole (120), a part of a projection of the sound hole (120) in a direction perpendicular to the first substrate (110) is covered with a projection of the electrostatic interception portion (109) in a direction perpendicular to the first substrate (110); and
the electrostatic interception portion (109) comprises at least one baffle, and a part of the sound hole (120) is configured to be blocked by the at least one baffle.

## Patentansprüche

1. Mikrofonstruktur (10), wobei die Mikrofonstruktur (10) umfasst:
ein Basiselement (100), wobei das Basiselement (100) mindestens ein Substrat umfasst, wobei das mindestens eine Substrat ein erstes Substrat (110) umfasst, wobei das erste Substrat (110) eine erste Oberfläche (1101) und eine der ersten Oberfläche (1101) gegenüberliegende zweite Oberfläche (1102) aufweist, wobei auf dem ersten Substrat (110) eine Schallöffnung (120) angeordnet ist und die Schallöffnung (120) das erste Substrat (110) in Dickenrichtung durchdringt; und eine Funktionsbaugruppe (200), wobei die Funktionsbaugruppe (200) eine erste Funktionsbaugruppe (210) und eine zweite Funktionsbaugruppe (220) umfasst, wobei die erste Funktionsbaugruppe (210) eine akustische Vorrichtung (2101-1) und eine dritte Funktionsbaugruppe (2101-2) umfasst, wobei die akustische Vorrichtung (2101-1) so konfiguriert ist, dass sie eine Schallwelle aus der Schallöffnung (120) empfängt, die erste Funktionsbaugruppe (210) ist auf der ersten Oberfläche (1101) des ersten Substrats (110) angeordnet, und die zweite Funktionsbaugruppe (220) ist auf der zweiten Oberfläche (1102) des ersten Substrats (110) angeordnet;
wobei die dritte Funktionsbaugruppe (2101-2) einen ersten Metallabschnitt (2102) und einen ersten Isolierabschnitt (2103) umfasst, der erste Metallabschnitt (2102) auf der ersten Oberfläche (1101) des ersten Substrats (110) angeordnet ist, ein Teil des ersten Metallabschnitts (2102) oder der gesamte erste Metallabschnitt (2102) mit dem ersten Isolierabschnitt (2103) bedeckt ist; die zweite Funktionsbaugruppe (220) umfasst einen zweiten Metallabschnitt (2201) und einen zweiten Isolierabschnitt (2202), wobei der zweite Metallabschnitt (2201) auf der zweiten Oberfläche (1102) des ersten Substrats (110) angeordnet ist, ein Teil des zweiten Metallabschnitts (2201) ist mit dem zweiten Isolierabschnitt (2202) bedeckt, sodass ein der Schallöffnung (120) zugewandtes Ende des zweiten Metallabschnitts (2201) freiliegt; der erste Metallabschnitt (2102) ist so ausgebildet, dass er elektrisch mit der Masse des ersten Substrats (110) verbunden ist; der zweite Metallabschnitt (2201) ist so ausgebildet, dass er elektrisch mit der Masse des ersten Substrats (110) oder mit einer Schaltung zur Ableitung elektrostatischer Entladungen verbunden ist, und der erste Metallabschnitt (2102) sowie der zweite Metallabschnitt (2201) sind jeweils so ausgebildet, dass sie die Schallöffnung (120) umgeben;
**dadurch gekennzeichnet, dass** der zweite Metallabschnitt (2201) eine erste Erdungskomponente (22011) und eine zweite Erdungskomponente (22012) umfasst, die jeweils die Schallöffnung (120) umgeben, wobei sowohl die erste Erdungskomponente (22011) als auch die zweite Erdungskomponente (22012) Metallringe sind, der Außendurchmesser der ersten Erdungskomponente (22011) kleiner ist als der Innendurchmesser der zweiten Erdungskomponente (22012), die Schallöffnung (120) in einem ringförmigen Bereich angeordnet ist, der durch den Innendurchmesser der ersten Erdungskomponente (22011) definiert ist, die Breite des Metallrings, der die erste Erdungskomponente (22011) bildet, kleiner ist als die Breite des Metallrings, der die zweite Erdungskomponente (22012) bildet, und die erste Erdungskomponente (22011) und die zweite Erdungskomponente (22012) über ein Durchgangsloch, das das erste Substrat (110) durchdringt, elektrisch mit dem ersten Metallabschnitt (2102) verbunden sind.

2. Mikrofonstruktur (10) nach Anspruch 1, wobei ein Abstand (L1) zwischen dem ersten Metallabschnitt (2102) und der Schallöffnung (120) zuzüglich einer Dicke (H) des ersten Substrats (110) größer ist als ein Abstand (L2) zwischen dem zweiten Metallabschnitt (2201) und der Schallöffnung (120), und/oder eine Fläche (S1) des ersten Metallabschnitts (2102) kleiner ist als eine Fläche (S2) des zweiten Metallabschnitts (2201), und/oder der Abstand (L1) zwischen dem ersten Metallabschnitt (2102) und der Schallöffnung (120) größer ist als der Abstand (L2) zwischen dem zweiten Metallabschnitt (2201) und der Schallöffnung (120).

3. Mikrofonstruktur (10) nach Anspruch 1, wobei die Summe aus einem Abstand (a) zwischen dem ersten Metallabschnitt (2102) und einer Mittelachse der Schallöffnung (120) sowie einem Abstand (b) vom ersten Metallabschnitt (2102) zu einer Außenfläche der zweiten Funktionsbaugruppe (220) in Richtung der Mittelachse der Schallöffnung (120) größer ist als die Summe aus einem Abstand (c) zwischen der ersten Erdungskomponente (22011) und der Mittelachse der Schallöffnung (120) sowie einem Abstand (d) von der ersten Erdungskomponente (22011) zur Außenfläche der zweiten Funktionsbaugruppe (220) in Richtung der Mittelachse der Schallöffnung (120), und/oder die Fläche des ersten Metallabschnitts (2102) kleiner ist als die Fläche der ersten Erdungskomponente (22011).

4. Mikrofonstruktur (10) nach Anspruch 1, wobei das Basiselement (100) ferner ein zweites Substrat (111) umfasst, das zweite Substrat (111) auf einer von der akustischen Vorrichtung (2101-1) abgewandten Seite des ersten Substrats (110) angeordnet ist, die zweite Funktionsbaugruppe (220) ferner ein Schallführungsrohr (2203) und ein Gesamtvorrichtungsgehäuse (2204) umfasst, das Schallführungsrohr (2203) auf der zweiten Oberfläche (1102) des ersten Substrats (110) angeordnet ist, und das Schallführungsrohr (2203) verläuft durch das zweite Substrat (111) und das Gesamtvorrichtungsgehäuse (2204), wobei das erste Substrat (110), das zweite Substrat (111) und das Gesamtvorrichtungsgehäuse (2204) jeweils so ausgebildet sind, dass sie die Schallöffnung (120) umgeben.

5. Mikrofonstruktur (10) nach Anspruch 4, wobei ein Metallblock (102) an einem Ende einer Innenwand eines Rohrkörpers des Schallführungsrohrs (2203) angeordnet ist, das von der akustischen Vorrichtung (2101-1) abgewandt ist, und der Metallblock (102) so ausgebildet ist, dass er in Richtung einer Innenwand der Schallöffnung (120) freiliegt;
die Dicke des Metallblocks (102) ist geringer als die Wandstärke des Rohrkörpers des Schallführungsrohrs (2203), und die Länge des Metallblocks (102) entlang der Achsenrichtung des Rohrkörpers ist geringer als die Länge des Rohrkörpers des Schallführungsrohrs (2203).

6. Mikrofonstruktur (10) nach Anspruch 4, wobei durch das Schallführungsrohr (2203) zwischen dem zweiten Substrat (111) und dem Gesamtvorrichtungsgehäuse (2204) ein Biegeweg (104) definiert ist, die Länge des Biegewegs (104) größer ist als der Abstand vom zweiten Substrat (111) zum Gesamtvorrichtungsgehäuse (2204) und eine Schallwelle so ausgelegt ist, dass sie durch den Biegeweg (104) in die Schallöffnung (120) eintritt;
das Schallführungsrohr (2203) eine erste Öffnung (104-1) und eine zweite Öffnung (104-2) umfasst, wobei die erste Öffnung (104-1) so ausgebildet ist, dass sie mit der Schallöffnung (120) in Verbindung steht, die zweite Öffnung (104-2) ist so ausgebildet, dass sie mit einem Außenraum in Verbindung steht, wobei eine Mittelachse der ersten Öffnung (104-1) und eine Mittelachse der zweiten Öffnung (104-2) zueinander versetzt sind.

7. Mikrofonstruktur (10) nach Anspruch 1, wobei die dritte Funktionsbaugruppe (2101-2) ferner eine elektrostatische Ableitvorrichtung (300) umfasst, wobei die elektrostatische Ableitvorrichtung (300) so ausgelegt ist, dass sie einen in die akustische Vorrichtung (2101-1) eintretenden ESD-Lichtbogen absorbiert, und wobei die elektrostatische Ableitvorrichtung (300) so ausgelegt ist, dass sie den absorbierten ESD-Lichtbogen über den ersten Metallabschnitt (2102) und den zweiten Metallabschnitt (2201) ableitet.

8. Mikrofonstruktur (10) nach Anspruch 7, wobei eine Nut (301) auf der ersten Oberfläche (1101) des ersten Substrats (110) angeordnet ist, wobei die Nut (301) in einer von der akustischen Vorrichtung (2101-1) abgewandten Richtung vorsteht und die Nut (301) so ausgebildet ist, dass sie die elektrostatische Ableitvorrichtung (300) aufnimmt;
die Tiefe der Nut (301) ist größer oder gleich der Höhe der elektrostatischen Ableitvorrichtung (300) in einer Dickenrichtung des ersten Substrats (110);
die elektrostatische Ableitvorrichtung (300) ist eine Diodenvorrichtung, wobei eine Anode der Diodenvorrichtung so ausgebildet ist, dass sie elektrisch mit der akustischen Vorrichtung (2101-1) verbunden ist, und eine Kathode der Diodenvorrichtung so ausgebildet ist, dass sie elektrisch mit dem ersten Metallabschnitt (2102) verbunden ist.

9. Mikrofonstruktur (10), wobei die Mikrofonstruktur (10) umfasst:
ein Basiselement (100), wobei das Basiselement (100) mindestens ein Substrat umfasst, wobei das mindestens eine Substrat ein erstes Substrat (110) umfasst, das erste Substrat (110) eine erste Oberfläche (1101) und eine der ersten Oberfläche (1101) gegenüberliegende zweite Oberfläche (1102) aufweist, wobei auf dem ersten Substrat (110) eine Schallöffnung (120) angeordnet ist und die Schallöffnung (120) das erste Substrat (110) in Dickenrichtung durchdringt; sowie
eine Funktionsbaugruppe (200), wobei die Funktionsbaugruppe (200) eine erste Funktionsbaugruppe (210) und eine zweite Funktionsbaugruppe (220) umfasst, wobei die erste Funktionsbaugruppe (210) eine akustische Vorrichtung (2101-1) und eine dritte Funktionsbaugruppe (2101-2) umfasst, wobei die akustische Vorrichtung (2101-1) so ausgelegt ist, dass sie eine Schallwelle aus der Schallöffnung (120) empfängt, die erste Funktionsbaugruppe (210) auf der ersten Oberfläche (1101) des ersten Substrats (110) angeordnet ist und die zweite Funktionsbaugruppe (220) auf der zweiten Oberfläche (1102) des ersten Substrats (110) angeordnet ist;
wobei die dritte Funktionsbaugruppe (2101-2) einen ersten Metallabschnitt (2102) und einen ersten Isolierabschnitt (2103) umfasst, der erste Metallabschnitt (2102) auf der ersten Oberfläche (1101) des ersten Substrats (110) angeordnet ist, wobei ein Teil des ersten Metallabschnitts (2102) oder der gesamte erste Metallabschnitt (2102) mit dem ersten Isolierabschnitt (2103) bedeckt ist; die zweite Funktionsbaugruppe (220) umfasst einen zweiten Metallabschnitt (2201) und einen zweiten Isolierabschnitt (2202), wobei der zweite Metallabschnitt (2201) auf der zweiten Oberfläche (1102) des ersten Substrats (110) angeordnet ist, ein Teil des zweiten Metallabschnitts (2201) ist mit dem zweiten Isolierabschnitt (2202) bedeckt, sodass ein der Schallöffnung (120) zugewandtes Ende des zweiten Metallabschnitts (2201) freiliegt; der erste Metallabschnitt (2102) ist so ausgebildet, dass er elektrisch mit der Masse des ersten Substrats (110) verbunden ist; der zweite Metallabschnitt (2201) ist so ausgebildet, dass er elektrisch mit der Masse des ersten Substrats (110) oder mit einer Schaltung zur Ableitung elektrostatischer Entladungen verbunden ist, und der erste Metallabschnitt (2102) sowie der zweite Metallabschnitt (2201) sind jeweils so ausgebildet, dass sie die Schallöffnung (120) umgeben;
**dadurch gekennzeichnet, dass** das Basiselement (100) ferner ein zweites Substrat (111) umfasst, das zweite Substrat (111) auf einer von der akustischen Vorrichtung (2101-1) abgewandten Seite des ersten Substrats (110) angeordnet ist, die zweite Funktionsbaugruppe (220) ferner ein Schallführungsrohr (2203) und ein Gesamtvorrichtungsgehäuse (2204) umfasst,
das Schallführungsrohr (2203) auf der zweiten Oberfläche (1102) des ersten Substrats (110) angeordnet ist und das zweite Substrat (111) sowie das Gesamtvorrichtungsgehäuse (2204) durchdringt; und das erste Substrat (110), das zweite Substrat (111) sowie das Gesamtvorrichtungsgehäuse (2204) sind jeweils so ausgebildet, dass sie die Schallöffnung (120) umgeben; und ein Metallblock (102) an einem Ende einer Innenwand eines Rohrkörpers des Schallführungsrohrs (2203) angeordnet ist, das von der akustischen Vorrichtung (2101-1) abgewandt ist, und der Metallblock (102) so ausgebildet ist, dass er zur Innenwand der Schallöffnung (120) hin freiliegt.

10. Mikrofonstruktur (10) nach Anspruch 9, wobei die Dicke des Metallblocks (102) geringer ist als die Wandstärke des Rohrkörpers des Schallführungsrohrs (2203) und die Länge des Metallblocks (102) entlang der Achsenrichtung des Rohrkörpers geringer ist als die Länge des Rohrkörpers des Schallführungsrohrs (2203).

11. Mikrofonstruktur (10), wobei die Mikrofonstruktur (10) umfasst:
ein Basiselement (100), wobei das Basiselement (100) mindestens ein Substrat umfasst, wobei das mindestens eine Substrat ein erstes Substrat (110) umfasst, wobei das erste Substrat (110) eine erste Oberfläche (1101) und eine der ersten Oberfläche gegenüberliegende zweite Oberfläche (1102) aufweist, wobei auf dem ersten Substrat (110) eine Schallöffnung (120) angeordnet ist und die Schallöffnung (120) das erste Substrat (110) in Dickenrichtung durchdringt; und
eine Funktionsbaugruppe (200), wobei die Funktionsbaugruppe (200) eine erste Funktionsbaugruppe (210) und eine zweite Funktionsbaugruppe (220) umfasst, wobei die erste Funktionsbaugruppe (210) eine akustische Vorrichtung (2101-1) und eine dritte Funktionsbaugruppe (2101-2) umfasst, wobei die akustische Vorrichtung (2101-1) so konfiguriert ist, dass sie eine Schallwelle aus der Schallöffnung (120) empfängt, wobei die erste Funktionsbaugruppe (210) auf der ersten Oberfläche (1101) des ersten Substrats (110) angeordnet ist, und die zweite Funktionsbaugruppe (220) ist auf der zweiten Oberfläche (1102) des ersten Substrats (110) angeordnet;
wobei die dritte Funktionsbaugruppe (2101-2) einen ersten Metallabschnitt (2102) und einen ersten Isolierabschnitt (2103) umfasst, wobei der erste Metallabschnitt (2102) auf der ersten Oberfläche (1101) des ersten Substrats (110) angeordnet ist und ein Teil des ersten Metallabschnitts (2102) oder der gesamte erste Metallabschnitt (2102) mit dem ersten Isolierabschnitt (2103) bedeckt ist; die zweite Funktionsbaugruppe (220) einen zweiten Metallabschnitt (2201) und einen zweiten Isolierabschnitt (2202) umfasst, der zweite Metallabschnitt (2201) auf der zweiten Oberfläche (1102) des ersten Substrats (110) angeordnet ist, ein Teil des zweiten Metallabschnitts (2201) mit dem zweiten Isolierabschnitt (2202) bedeckt ist, sodass ein der Schallöffnung (120) zugewandtes Ende des zweiten Metallabschnitts (2201) freiliegt; der erste Metallabschnitt (2102) so ausgebildet ist, dass er elektrisch mit der Masse des ersten Substrats (110) verbunden ist; der zweite Metallabschnitt (2201) so ausgebildet ist, dass er elektrisch mit der Masse des ersten Substrats (110) oder mit einer Schaltung zur Ableitung elektrostatischer Entladungen verbunden ist, und der erste Metallabschnitt (2102) sowie der zweite Metallabschnitt (2201) jeweils so ausgebildet sind, dass sie die Schallöffnung (120) umgeben;
**dadurch gekennzeichnet, dass** mindestens ein Spitzenabschnitt (108) an dem zweiten Metallabschnitt (2201) angeordnet ist, wobei ein Ende des Spitzenabschnitts (108) an einer Innenkante des zweiten Metallabschnitts (2201) befestigt ist und das andere Ende des Spitzenabschnitts (108) so ausgebildet ist, dass es sich in Richtung eines geometrischen Zentrums der Schallöffnung (120) erstreckt.

12. Mikrofonstruktur (10) nach Anspruch 11, wobei eine Länge des Spitzenabschnitts (108) größer oder gleich einem Abstand von der Innenkante des zweiten Metallabschnitts (2201) zu einer Kante der Schallöffnung (120) ist; oder
eine Projektion jedes Spitzenabschnitts (108) auf die zweite Oberfläche (1102) des ersten Substrats (110) ein spitzwinkliges Dreieck ist und ein spitzer Winkel jedes spitzwinkligen Dreiecks auf den geometrischen Mittelpunkt der Schallöffnung (120) zeigt.

13. Mikrofonstruktur (10) nach Anspruch 11, wobei ein elektrostatischer Auffangabschnitt (109) an einem Ende des zweiten Metallabschnitts (2201) nahe der Schallöffnung (120) angeordnet ist, ein Teil des Projektionsbildes der Schallöffnung (120) in einer Richtung senkrecht zum ersten Substrat (110) durch ein Projektionsbild des elektrostatischen Auffangabschnitts (109) in einer Richtung senkrecht zum ersten Substrat (110) abgedeckt ist; und
der elektrostatische Auffangabschnitt (109) mindestens eine Prallplatte umfasst und ein Teil der Schallöffnung (120) so ausgebildet ist, dass er durch die mindestens eine Prallplatte blockiert wird.

## Revendications

1. Structure de microphone (10), dans laquelle la structure de microphone (10) comprend: un composant de base (100), le composant de base (100) comprenant au moins un substrat, ledit au moins un substrat comprenant un premier substrat (110), le premier substrat (110) présentant une première surface (1101) et une deuxième surface (1102) opposée à la première surface (1101), dans laquelle un orifice acoustique (120) est disposé sur le premier substrat (110), et l'orifice acoustique (120) traverse le premier substrat (110) dans le sens de l'épaisseur; et un ensemble fonctionnel (200), l'ensemble fonctionnel (200) comprenant un premier ensemble fonctionnel (210) et un deuxième ensemble fonctionnel (220), le premier ensemble fonctionnel (210) comprenant un dispositif acoustique (2101-1) et un troisième ensemble fonctionnel (2101-2), le dispositif acoustique (2101-1) étant configuré pour recevoir une onde sonore provenant de l'orifice acoustique (120), le premier ensemble fonctionnel (210) est disposé sur la première surface (1101) du premier substrat (110), et le deuxième ensemble fonctionnel (220) est disposé sur la deuxième surface (1102) du premier substrat (110); dans lequel le troisième ensemble fonctionnel (2101-2) comprend une première partie métallique (2102) et une première partie isolante (2103), la première partie métallique (2102) est disposée sur la première surface (1101) du premier substrat (110), une partie de la première partie métallique (2102) ou la totalité de celle-ci est recouverte par la première partie isolante (2103); le deuxième ensemble fonctionnel (220) comprend une deuxième partie métallique (2201) et une deuxième partie isolante (2202), la deuxième partie métallique (2201) étant disposée sur la deuxième surface (1102) du premier substrat (110), une partie de la deuxième partie métallique (2201) est recouverte par la deuxième partie isolante (2202), de sorte qu'une extrémité de la deuxième partie métallique (2201) faisant face à l'orifice acoustique (120) soit exposée, la première partie métallique (2102) est configurée pour être connectée électriquement à la masse du premier substrat (110), la deuxième partie métallique (2201) est configurée pour être reliée électriquement à la masse du premier substrat (110) ou à un circuit de décharge électrostatique, et la première partie métallique (2102) et la deuxième partie métallique (2201) sont respectivement configurées pour entourer l'orifice acoustique (120); **caractérisée en ce que** la deuxième partie métallique (2201) comprend un premier composant de mise à la terre (22011) et un deuxième composant de mise à la terre (22012) entourant respectivement l'orifice acoustique (120), le premier composant de mise à la terre (22011) et le deuxième composant de mise à la terre (22012) étant tous deux des anneaux métalliques, le diamètre extérieur du premier composant de mise à la terre (22011) est inférieur au diamètre intérieur du deuxième composant de mise à la terre (22012), l'orifice acoustique (120) est disposé dans une région annulaire définie par le diamètre intérieur du premier composant de mise à la terre (22011), la largeur de l'anneau métallique constituant le premier composant de mise à la terre (22011) est inférieure à la largeur de l'anneau métallique constituant le deuxième composant de mise à la terre (22012), et le premier composant de mise à la terre (22011) et le deuxième composant de mise à la terre (22012) sont reliés électriquement à la première partie métallique (2102) par l'intermédiaire d'un trou de passage traversant le premier substrat (110).

2. Structure de microphone (10) selon la revendication 1, dans laquelle une distance (L1) entre la première partie métallique (2102) et l'orifice acoustique (120), augmentée d'une épaisseur (H) du premier substrat (110), est supérieure à une distance (L2) entre la deuxième partie métallique (2201) et l'orifice acoustique (120), et/ou une surface (S1) de la première partie métallique (2102) est inférieure à une surface (S2) de la deuxième partie métallique (2201), et/ou la distance (L1) entre la première partie métallique (2102) et l'orifice acoustique (120) est supérieure à la distance (L2) entre la deuxième partie métallique (2201) et l'orifice acoustique (120).

3. Structure de microphone (10) selon la revendication 1, dans laquelle la somme d'une distance (a) entre la première partie métallique (2102) et l'axe central de l'orifice acoustique (120) et d'une distance (b) entre la première partie métallique (2102) et une surface extérieure du deuxième ensemble fonctionnel (220) dans la direction de l'axe central de l'orifice acoustique (120) est supérieure à la somme d'une distance (c) entre le premier composant de mise à la terre (22011) et l'axe central de l'orifice acoustique (120) et d'une distance (d) entre le premier composant de mise à la terre (22011) et la surface extérieure du deuxième ensemble fonctionnel (220) dans la direction de l'axe central de l'orifice acoustique (120), et/ou la surface de la première partie métallique (2102) est inférieure à la surface du premier composant de mise à la terre (22011).

4. Structure de microphone (10) selon la revendication 1, dans laquelle le composant de base (100) comprend en outre un deuxième substrat (111), le deuxième substrat (111) étant disposé sur un côté du premier substrat (110) opposé au dispositif acoustique (2101-1), le deuxième ensemble fonctionnel (220) comprend en outre un tube de guidage acoustique (2203) et un boîtier de l'appareil (2204), le tube de guidage acoustique (2203) étant disposé sur la deuxième surface (1102) du premier substrat (110), et le tube de guidage acoustique (2203) traverse le deuxième substrat (111) et le boîtier de l'appareil (2204), le premier substrat (110), le deuxième substrat (111) et le boîtier de l'appareil (2204) sont respectivement configurés pour entourer l'orifice acoustique (120).

5. Structure de microphone (10) selon la revendication 4, dans laquelle un bloc métallique (102) est disposé à une extrémité d'une paroi interne d'un corps de tube du tube de guidage acoustique (2203) opposée au dispositif acoustique (2101-1), et le bloc métallique (102) est configuré pour faire saillie vers une paroi interne de l'orifice acoustique (120); l'épaisseur du bloc métallique (102) est inférieure à l'épaisseur de paroi du corps du tube de guidage acoustique (2203), et la longueur du bloc métallique (102) dans la direction de l'axe du corps du tube est inférieure à la longueur du corps du tube de guidage acoustique (2203).

6. Structure de microphone (10) selon la revendication 4, dans laquelle un conduit courbé (104) est défini par le tube de guidage acoustique (2203) entre le deuxième substrat (111) et le boîtier de l'ensemble de boîtier de l'appareil (2204), la longueur du conduit courbé (104) est supérieure à la distance entre le deuxième substrat (111) et le boîtier de l'appareil (2204), et une onde sonore est configurée pour pénétrer dans l'orifice acoustique (120) par le biais du conduit courbé (104);
le tube de guidage acoustique (2203) comprend une première ouverture (104-1) et une deuxième ouverture (104-2), la première ouverture (104-1) étant agencée pour communiquer avec l'orifice acoustique (120), la deuxième ouverture (104-2) est agencée pour communiquer avec un espace extérieur; l'axe central de la première ouverture (104-1) et l'axe central de la deuxième ouverture (104-2) sont décalés l'un par rapport à l'autre.

7. Structure de microphone (10) selon la revendication 1, dans laquelle le troisième ensemble fonctionnel (2101-2) comprend en outre un dispositif de décharge électrostatique (300), le dispositif de décharge électrostatique (300) étant configuré pour absorber un arc ESD pénétrant dans le dispositif acoustique (2101-1), et le dispositif de décharge électrostatique (300) étant configuré pour décharger l'arc ESD absorbé par l'intermédiaire de la première partie métallique (2102) et de la deuxième partie métallique (2201).

8. Structure de microphone (10) selon la revendication 7, dans laquelle une rainure (301) est disposée sur la première surface (1101) du premier substrat (110), et la rainure (301) fait saillie dans une direction opposée au dispositif acoustique (2101-1), et la rainure (301) est configurée pour recevoir le dispositif de décharge électrostatique (300); la profondeur de la rainure (301) est supérieure ou égale à la hauteur du dispositif de décharge électrostatique (300) dans le sens de l'épaisseur du premier substrat (110); le dispositif de décharge électrostatique (300) est un dispositif à diode, l'anode du dispositif à diode est configurée pour être connectée électriquement au dispositif acoustique (2101-1), et la cathode du dispositif à diode est configurée pour être connectée électriquement à la première partie métallique (2102).

9. Structure de microphone (10), dans laquelle la structure de microphone (10) comprend: un composant de base (100), le composant de base (100) comprenant au moins un substrat, ledit au moins un substrat comprenant un premier substrat (110), le premier substrat (110) présente une première surface (1101) et une deuxième surface (1102) opposée à la première surface (1101), dans laquelle un orifice acoustique (120) est disposé sur le premier substrat (110), et l'orifice acoustique (120) traverse le premier substrat (110) dans le sens de l'épaisseur; et un ensemble fonctionnel (200), l'ensemble fonctionnel (200) comprenant un premier ensemble fonctionnel (210) et un deuxième ensemble fonctionnel (220), le premier ensemble fonctionnel (210) comprenant un dispositif acoustique (2101-1) et un troisième ensemble fonctionnel (2101-2), le dispositif acoustique (2101-1) est configuré pour recevoir une onde sonore provenant de l'orifice acoustique (120), le premier ensemble fonctionnel (210) est disposé sur la première surface (1101) du premier substrat (110), et le deuxième ensemble fonctionnel (220) est disposé sur la deuxième surface (1102) du premier substrat (110); dans lequel le troisième ensemble fonctionnel (2101-2) comprend une première partie métallique (2102) et une première partie isolante (2103), la première partie métallique (2102) est disposée sur la première surface (1101) du premier substrat (110), une partie de la première partie métallique (2102) ou la totalité de celle-ci est recouverte par la première partie isolante (2103); le deuxième ensemble fonctionnel (220) comprend une deuxième partie métallique (2201) et une deuxième partie isolante (2202), la deuxième partie métallique (2201) étant disposée sur la deuxième surface (1102) du premier substrat (110), une partie de la deuxième partie métallique (2201) est recouverte par la deuxième partie isolante (2202), de sorte qu'une extrémité de la deuxième partie métallique (2201) tournée vers l'orifice acoustique (120) soit exposée, la première partie métallique (2102) est configurée pour être connectée électriquement à la masse du premier substrat (110), la deuxième partie métallique (2201) est configurée pour être reliée électriquement à la masse du premier substrat (110) ou à un circuit de décharge électrostatique, et la première partie métallique (2102) et la deuxième partie métallique (2201) sont respectivement configurées pour entourer l'orifice acoustique (120); **caractérisée en ce que** le composant de base (100) comprend en outre un deuxième substrat (111), le deuxième substrat (111) est disposé sur un côté du premier substrat (110) opposé au dispositif acoustique (2101-1), le deuxième ensemble fonctionnel (220) comprend en outre un tube de guidage acoustique (2203) et un boîtier de l'appareil (2204), le tube de guidage acoustique (2203) est disposé sur la deuxième surface (1102) du premier substrat (110) et traverse le deuxième substrat (111) ainsi que le boîtier de l'ensemble de boîtier de l'appareil (2204), et le premier substrat (110), le deuxième substrat (111) et le boîtier de l'appareil (2204) sont respectivement configurés pour entourer l'orifice acoustique (120); et un bloc métallique (102) est disposé à une extrémité d'une paroi interne du corps du tube de guidage acoustique (2203) opposée au dispositif acoustique (2101-1), et le bloc métallique (102) est configuré pour faire saillie vers une paroi interne de l'orifice acoustique (120).

10. Structure de microphone (10) selon la revendication 9, dans laquelle l'épaisseur du bloc métallique (102) est inférieure à l'épaisseur de paroi du corps du tube de guidage acoustique (2203), et la longueur du bloc métallique (102) dans la direction de l'axe du corps du tube est inférieure à la longueur du corps du tube de guidage acoustique (2203).

11. Structure de microphone (10), dans laquelle la structure de microphone (10) comprend: un composant de base (100), le composant de base (100) comprenant au moins un substrat, ledit au moins un substrat comprenant un premier substrat (110), le premier substrat (110) présentant une première surface (1101) et une deuxième surface (1102) opposée à la première surface (1101), dans laquelle un orifice acoustique (120) est disposé sur le premier substrat (110), et l'orifice acoustique (120) traverse le premier substrat (110) dans le sens de l'épaisseur; et un ensemble fonctionnel (200), l'ensemble fonctionnel (200) comprenant un premier ensemble fonctionnel (210) et un deuxième ensemble fonctionnel (220), le premier ensemble fonctionnel (210) comprenant un dispositif acoustique (2101-1) et un troisième ensemble fonctionnel (2101-2), le dispositif acoustique (2101-1) étant configuré pour recevoir une onde sonore provenant de l'orifice acoustique (120), le premier ensemble fonctionnel (210) étant disposé sur la première surface (1101) du premier substrat (110), et le deuxième ensemble fonctionnel (220) est disposé sur la deuxième surface (1102) du premier substrat (110); dans lequel le troisième ensemble fonctionnel (2101-2) comprend une première partie métallique (2102) et une première partie isolante (2103), la première partie métallique (2102) est disposée sur la première surface (1101) du premier substrat (110), une partie de la première partie métallique (2102) ou la totalité de celle-ci est recouverte par la première partie isolante (2103); le deuxième ensemble fonctionnel (220) comprend une deuxième partie métallique (2201) et une deuxième partie isolante (2202); la deuxième partie métallique (2201) est disposée sur la deuxième surface (1102) du premier substrat (110); une partie de la deuxième partie métallique (2201) est recouverte par la deuxième partie isolante (2202), de sorte qu'une extrémité de la deuxième partie métallique (2201) tournée vers l'orifice acoustique (120) soit exposée, la première partie métallique (2102) est configurée pour être connectée électriquement à la masse du premier substrat (110), la deuxième partie métallique (2201) est configurée pour être reliée électriquement à la masse du premier substrat (110) ou à un circuit de décharge électrostatique, et la première partie métallique (2102) et la deuxième partie métallique (2201) sont respectivement configurées pour entourer l'orifice acoustique (120); **caractérisée en ce qu'**au moins une partie d'embout (108) est disposée sur la deuxième partie métallique (2201), une extrémité de la partie d'embout (108) est fixée à un bord intérieur de la deuxième partie métallique (2201), l'autre extrémité de la partie d'embout (108) est agencée pour s'étendre vers un centre géométrique de l'orifice acoustique (120).

12. Structure de microphone (10) selon la revendication 11, dans laquelle la longueur de la partie d'embout (108) est supérieure ou égale à la distance entre le bord intérieur de la deuxième partie métallique (2201) et un bord de l'orifice acoustique (120); ou la projection de chaque partie d'embout (108) sur la deuxième surface (1102) du premier substrat (110) forme un triangle aigu, et un angle aigu de chaque triangle aigu est orienté vers le centre géométrique de l'orifice acoustique (120).

13. Structure de microphone (10) selon la revendication 11, dans laquelle une partie d'interception électrostatique (109) est disposée à une extrémité de la deuxième partie métallique (2201) proche de l'orifice acoustique (120), une partie de la projection de l'orifice acoustique (120) dans une direction perpendiculaire au premier substrat (110) est recouverte par une projection de la partie d'interception électrostatique (109) dans une direction perpendiculaire au premier substrat (110); et la partie d'interception électrostatique (109) comprend au moins un déflecteur, et une partie de l'orifice acoustique (120) est configurée pour être obstruée par ledit au moins un déflecteur.
